# EUROPEAN PATENT APPLICATION

(11) **EP 4 557 904 A1**
(43) Date of publication of application: **21.05.2025**
(21) Application number: 24756004.8
(22) Date of filing: 01.02.2024
(51) Int. Cl.: H05K 7/20

(54) **LIQUID COOLING MODULE, LIQUID COOLING MODULAR UNIT, AND ELECTRONIC DEVICE**

(30) Priority: 17.02.2023 CN 202310188740; 20.04.2023 CN 202310462273
(71) Applicant: Huawei Technologies Co., Ltd., Shenzhen, Guangdong 518129 (CN)
(72) Inventor: JIN, Linfang, Shenzhen, Guangdong 518129 (CN); LUO, Yang, Shenzhen, Guangdong 518129 (CN); FANG, Haoming, Shenzhen, Guangdong 518129 (CN); HU, Jinyan, Shenzhen, Guangdong 518129 (CN)
(74) Representative: Thun, Clemens
(86) International application number: PCT/CN2024/075186
(87) International publication number: WO 2024/169630

(57) **Abstract**

This application provides a liquid cooling module, a liquid cooling part, and an electronic device. The liquid cooling module includes a pump and the liquid cooling part. A pump base and the liquid cooling part are integrally sealed and connected. The liquid cooling part includes a flexible film and a rigid substrate. A material of each of the pump base and the liquid cooling part has elongation at break greater than 10%, and includes materials such as a polyethylene terephthalate copolymer, polyethylene naphthalate, polyethylene 2,5-furandicarboxylate, polyimide, polyetheretherketone, and biaxially oriented polypropylene. A monomer of polyethylene terephthalate copolymer includes terephthalic acid, ethylene glycol, and a hard segment molecular structure. The liquid cooling module in this application is formed through stacking of the pump and the liquid cooling part, material selection, and integrated welding, so that integrated sealing of a flexible system is implemented without a pre-tightening force, and no assembly leakage occurs. The liquid cooling module can dynamically adapt to bending use and fluctuations in system pressure and a volume, has higher temperature tolerance, and is used in a mobile electronic device like a bar phone, a foldable mobile phone, a foldable PC, a wearable device, or an accessory.

## Description

This application claims priorities to Chinese Patent Application No. 202310188740.1, filed with the China National Intellectual Property Administration on February 17, 2023, and entitled "HEAT DISSIPATION STRUCTURE"; and to Chinese Patent Application No. 202310462273.7, filed with the China National Intellectual Property Administration on April 20, 2023, and entitled "LIQUID COOLING MODULE, LIQUID COOLING PART, AND ELECTRONIC DEVICE", both of which are incorporated herein by reference in their entireties.

### TECHNICAL FIELD

This application relates to the field of electronic device technologies, and in particular, to a liquid cooling module, a liquid cooling part, and an electronic device.

### BACKGROUND

Currently, a mobile terminal, for example, a mobile phone, a watch, a tablet computer, or a wearable device, is limited by a size requirement and an ultra-thin requirement, and is mainly dissipated through a thermally uniform material like a thermal interface material (TIM), an artificial graphite film, a graphene film and a copper film, a heat pipe, a VC, a micro fan, and the like. Foldable mobile phones and foldable PCs are new mobile terminals that emerge recently and grow rapidly, and are popular among users. However, for the foldable mobile phone and the like, a hinge needs to pass a reliability test of bending at least 100,000 times. However, most heat dissipation components and materials, such as artificial graphite, the copper film, the heat pipe, and the VC, cannot pass the reliability test. In this case, the hinge separates two or three screens. A heat generation component like a SOC, a CPU, or a GPU and a charging chip are integrated on a mainboard of one of the screens. Consequently, it is difficult to transfer heat to other screens and board areas. This results in a temperature difference between the screens to be more than 10°C. An insufficient heat dissipation capability of a main heat generation component like the SOC, the CPU, or the GPU and charging chip results in heat concentration, which limits performance, and affects thermal experience of a user. A watch and a band also have similar problems. Heat generated by a watch face cannot be expanded to a strap, and there is no flexible heat dissipation solution.

A flexible heat dissipation solution using a through-hinge pump-driven liquid cooling system that can be applied to a PC, mobile phone, or watch is provided in CN114340305B. Compared with a conventional liquid cooling system, a simplified liquid cooling system without a liquid collection tank, a liquid filling apparatus, and an exhaust valve is provided. The system includes at least three connection hoses (made of bending-resistant and anti-evaporation PTFE with a metal coating), two cooling plates (made of stainless steel composite plates), two nozzles (made of 3D-printed stainless steel) connected to the cooling plates, one mechanical pump (a precision injection-molded part including three sealing rings that need to be connected through a plurality of bolts to provide a pre-tightening force), one four-way valve (which meets detection, debugging, and maintenance requirements), and the like. The system has at least 12 sealing interfaces in total. Sealing pipe connectors cannot be assembled automatically. After being tested, incoming materials from different suppliers are assembled, filled with liquid, and subject to sealing detection in a system factory. Metal pipes are generally used in the system, and an O-shaped ring sealing system with a pre-tightening force is used at a plurality of positions. In engineering, an interface sealing effect is closely related to a resilient force of an interface material, contact pressure, an amount of swelling of a sealing material on a liquid cooling medium, assembly precision of a to-be-assembled part, and the like. The O-shaped ring sealing system is related to incoming materials from a plurality of suppliers and production line assembly. As a result, automatic production cannot be achieved in engineering, quality control is difficult, and costs are high. Application scenarios of consumer products are complex and changeable. Especially, because mobile phones are often dropped or bent repeatedly during daily use, pre-tightening forces on a plurality of interfaces and long-term sealing reliability cannot be ensured. In addition, in a conventional liquid cooling module, a runner is formed by using a film material like polymer PET, PP, or PPS. Small molecules such as water penetrate a film made of a polymer material, and an amount of penetration increases with evaporation and a temperature index. Theoretically, adhesive can be used for sealing between a pump and a liquid cooling part, and sealing inside the liquid cooling part. Although characterized by ultra-thinness and ease of processing, adhesive, as a third different material between two sealing layers is difficult to accurately and reliably control during bonding, is likely to generate microbubbles between the layers during bonding, is excessively limited in long-term temperature and weather resistance, is especially not resistant to a high temperature and humidity, and is likely to creep or absorb moisture. This leads to a decrease and failure of a bonding force at an adhesive layer, and consequently, long-term reliable sealing cannot be achieved. Therefore, in engineering, adhesive is not used for sealing a liquid cooling system. In conclusion, leakage and evaporation problems become the biggest bottlenecks for using the conventional liquid cooling system in massive consumer electronic products of mobile terminals. For products such as foldable machines and wearables, an innovative sealing and heat dissipation solution for a flexible liquid cooling system is required.

### SUMMARY

This application provides a liquid cooling module, a liquid cooling part, and an electronic device. The liquid cooling module includes a pump and a liquid cooling part. The pump is configured to provide power for a cooling medium in the liquid cooling part, and the pump includes a pump base and a piezoelectric component. A pump liquid inlet and a pump liquid outlet are disposed on the pump base. The liquid cooling part includes a liquid cooling outlet and a liquid cooling inlet. The liquid cooling outlet is configured to communicate with the pump liquid inlet, and the liquid cooling inlet is configured to communicate with the pump liquid outlet. A part of the liquid cooling part on a periphery of the liquid cooling outlet and a part of the pump base on a periphery of the pump liquid inlet have a same material or similar materials, and are of an integrated sealing and welding structure without solder paste or another third material. A part of the liquid cooling part on a periphery of the liquid cooling inlet and a part of the pump base on a periphery of the pump liquid outlet have a same material or similar materials, and are of an integrated sealing and welding structure without solder paste or another third material. The liquid cooling part includes a first flexible film, a second flexible film, a first rigid substrate, a second rigid substrate, a third rigid substrate, and the like. The first rigid substrate and the second rigid substrate have a same material or similar materials as the first flexible film and the second flexible film, and an integrated sealing and welding structure without solder paste or another third material is used to seal the first rigid substrate and the second rigid substrate, and the first flexible film and the second flexible film. According to the liquid cooling module provided in this application, the liquid cooling module is formed through stacking of the pump and the liquid cooling film, material selection, and integrated welding, so that integrated sealing of a flexible system is implemented without a pre-tightening force. The liquid cooling module can dynamically adapt to bending use, fluctuations in system pressure and a volume, is simple in design and manufacturing, and has no assembly leakage. The liquid cooling module is used in a mobile electronic device like a bar phone, a foldable mobile phone, a foldable PC, a wearable device, or an accessory.

According to a first aspect, this application provides a liquid cooling module, where the liquid cooling module includes a pump and a liquid cooling part, the pump includes a pump base and a piezoelectric component fastened to the pump base, and a pump liquid inlet and a pump liquid outlet are disposed on the pump base. The liquid cooling part includes a liquid cooling outlet and a liquid cooling inlet, the liquid cooling outlet is configured to communicate with the pump liquid inlet, the liquid cooling inlet is configured to communicate with the pump liquid outlet, a part of the liquid cooling part on the periphery of the liquid cooling outlet and a part of the pump base on the periphery of the pump liquid inlet are of an integrated sealing structure, and a part of the liquid cooling part on the periphery of the liquid cooling inlet and a part of the pump base on the periphery of the pump liquid outlet are of an integrated sealing structure.

The pump, as a power source of the liquid cooling module, can provide flowing and circulating power for a cooling medium in the liquid cooling part, to implement active liquid cooling, thereby achieving an effect of persistent heat dissipation. Compared with passive liquid cooling, active liquid cooling can achieve an optimal heat dissipation effect through adjustment on a speed of the pump as required, while passive liquid cooling can implement only passive heat dissipation based on a temperature change of a component. Therefore, active liquid cooling has better adjustment performance. It should be noted that, that the liquid cooling outlet is configured to communicate with the pump liquid inlet does not mean that the liquid cooling outlet is always in a communication state with the pump liquid inlet, but means that the cooling medium can flow into the pump liquid inlet from the liquid cooling outlet under a specific condition. A relationship between the liquid cooling inlet and the pump liquid outlet is similar to that described above.

The piezoelectric component uses an inverse piezoelectric effect of a piezoelectric material. The piezoelectric material is a crystal material that generates a voltage between two end surfaces under pressure. The inverse piezoelectric effect means that after an electric field is applied to the piezoelectric component, mechanical deformation or mechanical pressure is generated in a specific direction on the piezoelectric component. When the applied electric field is removed, the deformation or stress disappears accordingly. The piezoelectric component is disposed in the pump, and has characteristics of a small size, high energy density, no electromagnetic interference, and the like, to implement precise transmission and control of a cooling medium. In an implementation, the piezoelectric component includes a piezoelectric ceramic, a metal substrate, a plastic spacer (a metal substrate that prevents a liquid working medium from corrosion), and the like.

In this implementation, the part of the liquid cooling part on the periphery of the liquid cooling outlet and the part of the pump base on the periphery of the pump liquid inlet are of the integrated sealing structure, and the part of the liquid cooling part on the periphery of the liquid cooling inlet and the part of the pump base on the periphery of the pump liquid outlet are of the integrated sealing structure. The forming the integrated sealing structure means that there are no continuous interfaces between two parts because of mutual integration and penetration, and the periphery of the liquid cooling outlet is an adjacent area around the liquid cooling outlet. If the liquid cooling part and the pump base are fastened in a screw connection manner, because the liquid cooling part and the pump base are separated components, a boundary between the liquid cooling part and the pump base is continuous. Compared with a structure made in a screw fastening manner, the integrated sealing structure in this application cannot be separated in general cases unless the integrated sealing structure is damaged by applying an external force. However, as the screw connection manner is adopted, the pump base and the liquid cooling part can be separated by only removing screws.

In a fastening manner using the screw connection, because a tightness degree (namely, a sealing effect) of the screw connection is limited by a plurality of factors such as assembly precision and a resilient force of a material, quality control is inconvenient, and the cooling medium may leak during actual use, thereby affecting heat dissipation efficiency of the cooling medium and damaging an internal component. In addition, a base usually needs to be disposed in the pump, and a screw passes through the base and the liquid cooling part in sequence to implement fastening. However, according to the integrated sealing structure in this application, the part of the liquid cooling part on the periphery of the liquid cooling outlet is integrated with the part of the pump base on the periphery of the pump liquid inlet, so that a connection relationship is closer. This helps improve a sealing effect between the pump base and the liquid cooling part, and an additional base is not required, thereby simplifying a structure of the liquid cooling module, reducing costs and processing difficulty, and achieving an ultra-thin design. In addition, the liquid cooling module provided in this application may be used in an electronic device. When the electronic device is subject to an external force (for example, when the electronic device falls to the ground and collides with the ground), the screw fastening manner may cause the pump base and the liquid cooling part to be connected loosely or not partially sealed tightly due to offset of an O-shaped ring. However, the pump base and the liquid cooling part are unlikely to have relative displacement because of the integrated sealing structure, thereby improving stability of an overall structure of the liquid cooling module and prolonging a service life of the electronic device.

In this application, the liquid cooling module is disposed as follows: First, the pump is configured to provide flowing and circulating power for the cooling medium, to implement active heat dissipation in the liquid cooling module. Compared with passive liquid cooling, active liquid cooling can reduce a temperature of a component more effectively, and improve heat dissipation efficiency.

Second, an area of the liquid cooling part on the periphery of the liquid cooling outlet and an area of the pump base on the periphery of the pump liquid inlet are of an integrated sealing structure, and an area of the liquid cooling part on the periphery of the liquid cooling inlet and an area of the pump base on the periphery of the pump liquid outlet are of an integrated sealing structure. Compared with the structure made in the screw fastening manner, the integrated sealing structure has a better sealing effect, and can prevent the cooling medium from leaking, thereby avoiding reducing heat dissipation efficiency of the cooling medium, and protecting components from being damaged.

In an implementation, centers of the liquid cooling outlet and the pump liquid inlet are aligned in a thickness direction of the liquid cooling module, and projections of areas enclosed by circumferential walls of the liquid cooling outlet and the pump liquid inlet overlap in the thickness direction. This solution helps reduce flow resistance of the cooling medium when the cooling medium passes through the liquid cooling outlet and the pump liquid inlet, and improve cooling efficiency.

In an implementation, centers of the liquid cooling inlet and the pump liquid outlet are aligned in a thickness direction of the liquid cooling module, and projections of areas enclosed by circumferential walls of the liquid cooling inlet and the pump liquid outlet overlap in the thickness direction. This solution helps reduce flow resistance of the cooling medium when the cooling medium passes through the liquid cooling inlet and the pump liquid outlet, and improve cooling efficiency.

In an implementation, at least a part of the part of the liquid cooling part on the periphery of the liquid cooling outlet and at least a part of the part of the pump base on the periphery of the pump liquid inlet are continuously integrated in a circumferential direction of the liquid cooling outlet, to form an integrated sealing structure.

In this implementation, to ensure a sealing effect between the pump base and the liquid cooling part, the integrated sealing structure needs to be continuously integrated into an integrated sealing structure in the circumferential direction of the liquid cooling outlet. In an implementation, a shape of the integrated sealing structure may be an ellipse, a square, a triangle, or an irregular pattern. In an implementation, an integrated sealing structure is formed on the periphery of the liquid cooling outlet in a radial direction.

In an implementation, in the radial direction of the liquid cooling outlet, there may be discontinuous interfaces between the part of the liquid cooling part on the periphery of the liquid cooling outlet and the part of the pump base on the periphery of the pump liquid inlet, and a spacing between the interfaces is not limited, where there is an integrated sealing structure at a position without an interface. In a preferred implementation, in the radial direction of the liquid cooling outlet, no interface is formed between the part of the liquid cooling part on the periphery of the liquid cooling outlet and the part of the pump base on the periphery of the pump liquid inlet, which is a preferred processing process with a best sealing effect.

It may be understood that, in this implementation, the radial direction and the circumferential direction are determined based on that a circular shape of the liquid cooling outlet. When the liquid cooling outlet is in another shape, the radial direction may be understood as a direction from a center of the liquid cooling outlet to a position on a periphery.

In an implementation, at least a part of the part of the liquid cooling part on the periphery of the liquid cooling inlet and at least a part of the part of the pump base on the periphery of the pump liquid outlet are continuously integrated in a circumferential direction of the liquid cooling inlet, to form an integrated sealing structure. In this solution, the integrated sealing structure on the periphery of the liquid cooling inlet is continuously integrated in the circumferential direction of the liquid cooling inlet.

In an implementation, the pump base includes a pump bottom wall, the pump bottom wall, the piezoelectric component, and a part of the pump base between the pump bottom wall and the piezoelectric component enclose a pump cavity, the pump liquid inlet and the pump liquid outlet are disposed on the pump bottom wall and communicate with the pump cavity, and the pump bottom wall and the part of the liquid cooling part on the periphery of the liquid cooling outlet, and the part of the liquid cooling part on the periphery of the liquid cooling inlet are of an integrated sealing structure.

In this implementation, a communication relationship between the pump liquid inlet and the pump cavity is similar to a communication relationship between the liquid cooling outlet and the pump liquid inlet. That is, the pump liquid inlet and the pump cavity are not always in communication, but under driving of the piezoelectric component, the cooling medium enters the pump cavity through the liquid cooling outlet and the pump liquid inlet. A communication relationship between the pump liquid outlet and the pump cavity is similar to that described above. In this implementation, both the pump liquid inlet and the pump liquid outlet are disposed on the pump bottom wall, and a part of the pump bottom wall on the periphery of the pump liquid inlet, a part of the pump bottom wall on the periphery of the pump liquid outlet, and a part of the liquid cooling part are of an integrated sealing structure, that is, no base needs to be additionally disposed in the pump. If a base is disposed in the pump, the base can be fastened to the liquid cooling part through only a screw, and consequently, a sealing effect is poor, and the cooling medium is prone to leakage. In addition, the pump liquid inlet and the pump liquid outlet usually need to be disposed outside the base, so that a circulation path of the cooling medium is extended, and heat dissipation efficiency of the cooling medium is reduced.

In this implementation, the liquid cooling module includes two pumps connected in parallel, and the two pumps connected in parallel can implement a larger flow volume. In another implementation, the liquid cooling module includes two pumps connected in series, and the two pumps connected in series can implement larger drive pressure. In another implementation, the liquid cooling module may include a plurality of pumps, and the plurality of pumps may be distributed at different positions in the liquid cooling module, and may be specifically disposed as required.

In an implementation, the pump further includes a liquid inlet valve film and a liquid outlet valve film that are fastened to the pump bottom wall, where the liquid inlet valve film is configured to close or open the pump liquid inlet, and the liquid outlet valve film is configured to close or open the pump liquid outlet.

In this implementation, in a liquid inlet scenario, the piezoelectric component is configured to: generate deformation after receiving an electrical signal, increase a size of the pump cavity, drive the liquid inlet valve film to open and the liquid outlet valve film to close, and provide power for the cooling medium in the liquid cooling part, so that the cooling medium enters the pump cavity through the liquid cooling outlet and the pump liquid inlet in sequence. In a liquid outlet scenario, the piezoelectric component is configured to: generate deformation after receiving an electrical signal, decrease a volume of the pump cavity, drive the liquid inlet valve film to close and the liquid outlet valve film to open, and provide power for the cooling medium in the liquid cooling part, so that the cooling medium enters the liquid cooling part through the pump liquid outlet and the liquid cooling inlet in sequence.

In this implementation, the liquid inlet valve film is located, in the thickness direction, on a side that is of the pump liquid inlet and that is away from the liquid cooling outlet, and the liquid outlet valve film is located, in the thickness direction, between the pump liquid outlet and the liquid cooling inlet. In another implementation, the liquid inlet valve film is located between the pump liquid inlet and the pump cavity in the thickness direction, and the liquid outlet valve film is located on a side that is of the liquid cooling inlet and that is away from the pump liquid outlet in the thickness direction.

It should be noted that, if the piezoelectric component is in a high temperature state for a long time, the piezoelectric component ages, causing performance degradation. Therefore, in this implementation, in addition to cooling a component of the electronic device, the liquid cooling module can further optimize performance of the pump included in the liquid cooling module.

In an implementation, the pump base further includes a pump side wall located between the pump bottom wall and the piezoelectric component, and the pump side wall is of an integrated sealing structure. In this implementation, the pump side wall extends in the thickness direction of the liquid cooling module. Because the pump side wall, the pump bottom wall, and the piezoelectric component jointly enclose the pump cavity, the pump side wall is of an integrated sealing structure in this solution, so that the cooling medium can be effectively prevented from leaking from the pump side wall, and sealing performance of the pump base can be improved.

In an implementation, the pump base includes a pump cavity layer, a first runner layer, a valve plate layer, and a second runner layer that are stacked in the thickness direction, a cavity hole is provided in the pump cavity layer, the pump liquid outlet and a first guide channel that corresponds to the pump liquid inlet are disposed in the first runner layer, and the first runner layer communicates with the cavity hole in the pump cavity layer; the liquid inlet valve film and the liquid outlet valve film that are openable and closeable are disposed in the valve plate layer, the pump liquid inlet and a second guide channel that corresponds to the pump liquid outlet are disposed in the second runner layer, and the second runner layer communicates with the liquid cooling part; and the pump cavity layer, the first runner layer, the valve plate layer, and the second runner layer form an integrated sealing structure through hot pressing.

In this implementation, the pump liquid inlet, the liquid inlet valve film, and the first guide channel are correspondingly disposed in the thickness direction of the liquid cooling module, and the pump liquid outlet, the liquid outlet valve film, and the second guide channel are correspondingly disposed in the thickness direction of the liquid cooling module. In this implementation, when the liquid inlet valve film is opened and the liquid outlet valve film is closed, the cooling medium sequentially passes through the liquid inlet valve film and the first guide channel through the pump liquid inlet to enter the pump cavity. When the liquid outlet valve film is opened and the liquid inlet valve film is closed, the cooling medium sequentially passes through the liquid outlet valve film and the second guide channel through the pump liquid outlet to enter the liquid cooling part. A projection area, in the thickness direction, of an area enclosed by a circumferential wall of the first guide channel is greater than a projection area, in the thickness direction, of an area enclosed by a circumferential wall of the pump liquid inlet. This helps prevent the cooling medium from flowing back to the pump liquid inlet, and achieves a guide effect of the first guide channel on the cooling medium. A projection area, in the thickness direction, of an area enclosed by a circumferential wall of the second guide channel is greater than a projection area, in the thickness direction, of an area enclosed by a circumferential wall of the pump liquid outlet. This helps prevent the cooling medium from flowing back to the liquid inlet and the liquid outlet of the pump, and achieves a guide effect of the second guide channel on the cooling medium.

In this implementation, edges of the pump cavity layer, the first runner layer, the valve plate layer, and the second runner layer form the pump side wall through hot pressing, so that each layer is sealed, and a sealing effect of the pump base is improved.

In an implementation, the liquid cooling part includes a first flexible film, the liquid cooling outlet and the liquid cooling inlet are disposed on the first flexible film, and the pump bottom wall, a part of the first flexible film on the periphery of the liquid cooling outlet, and a part of the first flexible film on the periphery of the liquid cooling inlet are of an integrated sealing structure.

In this implementation, fastening between the liquid cooling part and the pump is actually fastening between the first flexible film and the pump bottom wall. The part of the first flexible film on the periphery of the liquid cooling outlet, the part of the first flexible film on the periphery of the liquid cooling inlet, and the pump bottom wall are of the integrated sealing structure. Because the first flexible film and the pump bottom wall are made of a same material or similar materials, hot-pressing molding difficulty is small, thereby facilitating forming the integrated sealing structure.

In this implementation, there are discontinuous interfaces between the first flexible film and the pump bottom wall. In an implementation, the first flexible film and at least a part of the pump bottom wall are continuously integrated, to form the integrated sealing structure. In another implementation, a part of the first flexible film other than the liquid cooling outlet and the liquid cooling inlet, and the pump bottom wall are of an integrated sealing structure, and there is no interface between the part and the pump bottom wall. The sealing interface is a preferably a sealing interface, and has stronger flexibility, sealing performance, and impact resistance. However, it is difficult to achieve perfect processing in engineering. The interface is preferably a partially continuously-integrated interface, and there are micro-air gaps or non-welding areas in discontinuous contact between the interfaces.

In some implementations, to assist connection stability between the pump and the liquid cooling part, a position at which the pump is connected to the liquid cooling part 200 may be further sealed by using adhesive, thereby improving sealing performance and reliability.

In an implementation, a difference between a glass transition temperature of a material of the pump bottom wall and a glass transition temperature of a material of the first flexible film is less than or equal to 20°C. In this implementation, the difference between the glass transition temperature of the material of the pump bottom wall and the glass transition temperature of the material of the first flexible film is set to a small value, so that the pump bottom wall and the first flexible film are sealed into an integrated structure through thermo compression bonding, thereby improving a sealing effect between the pump bottom wall and the first flexible film.

In an implementation, a difference between a melting temperature of a material of the pump bottom wall and a melting temperature of a material of the first flexible film is less than or equal to 20°C. In this implementation, the difference between the melting temperature of the material of the pump bottom wall and the melting temperature of the material of the first flexible film is set to a small value, so that the pump bottom wall and the first flexible film are sealed into an integrated structure through thermo compression bonding, thereby improving a sealing effect between the pump bottom wall and the first flexible film.

In an implementation, a material of the part of the liquid cooling part on the periphery of the liquid cooling outlet is the same as a material of the part of the pump base on the periphery of the pump liquid inlet, and a material of the part of the liquid cooling part on the periphery of the liquid cooling inlet is the same as a material of the part of the pump base on the periphery of the pump liquid outlet. This solution helps form the integrated sealing structure between the part of the liquid cooling part on the periphery of the liquid cooling outlet and a part of the pump base, and form the integrated sealing structure between the part of the liquid cooling part on the periphery of the liquid cooling inlet and a part of the pump base, thereby helping avoid leakage of the cooling medium.

In an implementation, a material of the pump bottom wall is a flexible temperature-resistant polymer material with elongation at break greater than 10%, and the material of the pump bottom wall is selected from at least one of a polyethylene terephthalate copolymer, polyethylene naphthalate, polyethylene 2,5-furandicarboxylate, polyimide, polyetheretherketone, and biaxially oriented polypropylene. A material of the first flexible film is a flexible temperature-resistant polymer material with elongation at break greater than 10%, and the material of the first flexible film is selected from at least one of a polyethylene terephthalate copolymer, polyethylene naphthalate, polyethylene 2,5-furandicarboxylate, polyimide, polyetheretherketone, and biaxially oriented polypropylene. In this implementation, the materials selected for the pump bottom wall and the first flexible film help form the integrated sealing structure between the pump bottom wall and the first flexible film through hot pressing. The pump bottom wall and the first flexible film may be made of different materials, provided that the integrated sealing structure can be formed between the pump bottom wall and the first flexible film.

In an implementation, a monomer of the polyethylene terephthalate copolymer includes terephthalic acid, ethylene glycol, and a hard segment molecular structure, and a value of a mass percentage of the hard segment molecular structure to the polyethylene terephthalate copolymer is greater than or equal to 20% and less than or equal to 80%. In this solution, the hard segment molecular structure is introduced into a structure of the polyethylene terephthalate, so that a glass transition temperature of the polyethylene terephthalate copolymer can be increased. When the polyethylene terephthalate copolymer is applied to the liquid cooling module, the liquid cooling module can be applied to an application scenario of a medium-high temperature.

In this implementation, the hard segment molecular structure is set to the foregoing ratio, so that structural strength of the polyethylene terephthalate copolymer can be improved. When the polyethylene terephthalate copolymer is applied to the liquid cooling module, impact resistance and drop resistance of the liquid cooling module can be improved, and another component inside the electronic device can be effectively protected.

In an implementation, the hard segment molecular structure is selected from at least one of 2,5-furandicarboxylic acid, dimethyl carbonate, and 2,6-naphthalenedicarboxylic acid. In this implementation, the foregoing material is used as a hard segment molecular structure, so that structural strength of the polyethylene terephthalate copolymer can be improved. When another hard segment molecular structure other than the dimethyl carbonate is used, an evaporation problem of the first flexible film and the second flexible film can be further alleviated, and water permeability and air permeability can be reduced.

In an implementation, the liquid cooling part further includes a second flexible film and a first rigid substrate located between the first flexible film and the second flexible film, where the first flexible film, the second flexible film, and the first rigid substrate enclose an inner cavity of the liquid cooling part, and two ends of the first rigid substrate, the first flexible film, and the second flexible film are of an integrated sealing structure.

In this implementation, two interfaces for sealing and welding between the first rigid substrate and both the first flexible film and the second flexible film are made of a same material or similar materials. A welding manner without solder paste or another third material, for example, thermo compression bonding and seal welding, thermo melt welding, ultrasonic welding, or high frequency welding can be used to improve sealing performance and reliability between the first rigid substrate and both the first flexible film and the second flexible film. If leakage occurs in the sealing between the first rigid substrate and both the first flexible film and the second flexible film, system performance quickly decreases and becomes invalid.

In this implementation, the first flexible film and the second flexible film are flexible and have good bending performance, and are applicable to a case in which the liquid cooling part needs to be bent. The first rigid substrate is disposed between the first flexible film and the second flexible film, and two ends of the first rigid substrate are configured to support the first flexible film and the second flexible film, thereby helping improve overall strength of the liquid cooling part in the thickness direction. The cooling medium flows in the inner cavity enclosed by the first flexible film, the second flexible film, and the first rigid substrate. In this solution, two ends of the first rigid substrate, the first flexible film, and the second flexible film are of the integrated sealing structure, so that sealing performance of the inner cavity can be improved, and leakage of the cooling medium in the inner cavity can be avoided.

In this implementation, there are discontinuous interfaces among the two ends of the first rigid substrate, the first flexible film, and the second flexible film. In an implementation, the two ends of the first rigid substrate, at least a part of the first flexible film and at least a part of the second flexible film are continuously integrated, to form an integrated sealing structure. In another implementation, the two ends of the first rigid substrate, the first flexible film, and the second flexible film are all continuously integrated into an integrated sealing structure, there is no interface between the two ends of the first rigid substrate and the first flexible film, and there is no interface between the two ends of the first rigid substrate and the second flexible film. This helps further improve a sealing effect.

In an implementation, the first rigid substrate is disposed around edges of the first flexible film and the second flexible film. This solution helps improve strength of an edge of the liquid cooling part in the thickness direction, and the integrated sealing structure can effectively avoid leakage of the cooling medium at the edge of the liquid cooling part.

In an implementation, a thickness of the first flexible film and a thickness of the second flexible film are less than a length and a width of the liquid cooling module. Specifically, a ratio of each of the thickness of the first flexible film and the thickness of the second flexible film to the length of the liquid cooling module is less than or equal to 0.2, and a ratio of each of the thickness of the first flexible film and the thickness of the second flexible film to the width of the liquid cooling module is less than or equal to 0.2. When the liquid cooling module is used in a foldable device, this solution can ensure flexibility of the first flexible film and the second flexible film in a bending direction, and reduce bending difficulty of the device.

In an implementation, a material of each of the first flexible film and the second flexible film is made of a material with elongation at break greater than 10%, to adapt to system pressure fluctuation and bending use. Preferably, the material of each of the first flexible film and the second flexible film is a material with elongation at break greater than 50%. In an implementation, anti-evaporation coating processing is performed on surfaces of the first flexible film and the second flexible film. For example, a flexible inorganic oxide film is coated on a surface of a polymer film to isolate moisture.

In an implementation, a difference between a glass transition temperature of a material of the first rigid substrate and a glass transition temperature of a material of the first flexible film is less than or equal to 20°C. In this implementation, the difference between the glass transition temperature of the material of the first rigid substrate and the glass transition temperature of the material of the first flexible film is set to a small value, so that the first rigid substrate and the first flexible film are sealed into an integrated structure through thermo compression bonding, thereby improving a sealing effect between the first rigid substrate and the first flexible film.

In an implementation, a difference between a glass transition temperature of a material of the first rigid substrate and a glass transition temperature of a material of the second flexible film is less than or equal to 20°C. In this implementation, the difference between the glass transition temperature of the material of the first rigid substrate and the glass transition temperature of the material of the second flexible film is set to a small value, so that the first rigid substrate and the second flexible film are sealed into an integrated structure through thermo compression bonding, thereby improving a sealing effect between the first rigid substrate and the second flexible film.

In an implementation, a difference between a melting temperature of a material of the first rigid substrate and a melting temperature of a material of the first flexible film is less than or equal to 20°C. The difference between the melting temperature of the material of the first rigid substrate and the melting temperature of the material of the first flexible film is set to a small value, so that the first rigid substrate and the first flexible film are sealed into an integrated structure through thermo compression bonding, thereby improving a sealing effect between the first rigid substrate and the first flexible film.

In an implementation, a difference between a melting temperature of a material of the first rigid substrate and a melting temperature of a material of the second flexible film is less than or equal to 20°C. The difference between the melting temperature of the material of the first rigid substrate and the melting temperature of the material of the second flexible film is set to a small value, so that the first rigid substrate and the second flexible film are sealed into an integrated structure through thermo compression bonding, thereby improving a sealing effect between the first rigid substrate and the second flexible film.

In an implementation, at least one of the first flexible film and the second flexible film includes two sub-flexible film layers and an anti-evaporation layer located between the two sub-flexible film layers, and the anti-evaporation layer includes at least one of a polyimide layer, a polyvinylidene chloride layer, or a metal film layer.

In this implementation, a material of the sub-flexible film layer may be either of a material of the first flexible film or a material of the second flexible film. In an implementation, a material of the sub-flexible film layer may be the foregoing polyethylene terephthalate copolymer, PET copolymer for short.

In this implementation, a multi-layer film process is used for at least one of the first flexible film and the second flexible film, that is, the first flexible film and the second flexible film are disposed as a sandwich structure of "PET copolymer-X-PET copolymer", where the X layer is the anti-evaporation layer. Polyimide, polyvinylidene chloride, and a metal film are materials with a low moisture transmission rate. The anti-evaporation layer is made of the foregoing material, so that moisture evaporation in the first flexible film and the second flexible film can be reduced. In an implementation, a multi-layer co-extrusion technology or a multi-layer film compression technology is used to implement a multi-layer film structure in the first flexible film and the second flexible film.

In an implementation, the metal thin film layer may be a copper film, a nickel film, an aluminum film, or a metal-plastic composite film material, and has a thickness less than or equal to 10 micrometers. In this implementation, when the liquid cooling module is used in a foldable device, this solution helps ensure that the first flexible film and the second flexible film meet a requirement of 100,000 to 400,000 bending tests at different bending angles.

In an implementation, an inorganic oxide film is provided on a surface that is of at least one of the first flexible film and the second flexible film and that is away from the inner cavity. In this implementation, although surfaces that are of the first flexible film and the second flexible film and that are away from the inner cavity are not in direct contact with the cooling medium, both are interfaces through which the cooling medium should pass when evaporated to the outside. The inorganic oxide film is disposed, to help isolate moisture and alleviate an evaporation problem of the cooling medium.

In an implementation, the liquid cooling part further includes a second rigid substrate, the second rigid substrate separates the inner cavity of the liquid cooling part into a liquid inlet runner and a liquid outlet runner, the liquid cooling inlet communicates with the liquid inlet runner, the liquid cooling outlet communicates with the liquid outlet runner, and two ends of the second rigid substrate, the first flexible film, and the second flexible film are of an integrated sealing structure.

In this implementation, the two ends of the second rigid substrate, the first flexible film, and the second flexible film are of the integrated sealing structure, so that sealing performance and reliability are improved. If leakage occurs in separating and sealing between the second rigid substrate and both the first flexible film and the second flexible film, performance of the liquid cooling system greatly decreases and gradually becomes invalid.

In this implementation, the second rigid substrate is configured to separate a runner of the inner cavity into the liquid inlet runner and the liquid outlet runner, and each of the liquid inlet runner and the liquid outlet runner is enclosed by the second rigid substrate, the first rigid substrate, the first flexible film, and the second flexible film. The liquid inlet runner is kept in a communication state with the liquid cooling inlet, and the liquid outlet runner is kept in a communication state with the liquid cooling outlet. The liquid inlet runner and the liquid outlet runner are separated through the second rigid substrate. This helps avoid reducing cooling efficiency due to mixed flow of the cooling medium in the liquid inlet runner and the liquid outlet runner. The two ends of the second rigid substrate are integrally sealed with the first flexible film and the second flexible film through hot pressing. This helps improve an isolation effect between the liquid inlet runner and the liquid outlet runner, and can further improve structural strength of the liquid cooling part.

It may be understood that the liquid inlet runner and the liquid outlet runner are not two parts that are completely isolated, and the second rigid substrate merely separates the liquid inlet runner and the liquid outlet runner that are adjacent to the pump. To enable the cooling medium to circulate in the liquid cooling part, the liquid inlet runner and the liquid outlet runner communicate with each other in an area away from the pump.

In this implementation, there are discontinuous interfaces among the two ends of the second rigid substrate, the first flexible film, and the second flexible film. In an implementation, the two ends of the second rigid substrate, at least a part of the first flexible film and at least a part of the second flexible film are continuously integrated, to form an integrated sealing structure. In another implementation, the two ends of the second rigid substrate, the first flexible film, and the second flexible film are all continuously integrated into an integrated sealing structure, there is no interface between the two ends of the second rigid substrate and the first flexible film, and there is no interface between the two ends of the second rigid substrate and the second flexible film. This helps further improve a sealing effect.

In an implementation, the second rigid substrate includes a first sub-rigid substrate located below the pump and a second sub-rigid substrate located outside the pump, and an orthographic projection, on the second flexible film, of the first sub-rigid substrate does not overlap an orthographic projection, on the second flexible film, of an area enclosed by an edge of the liquid cooling inlet and an edge of the liquid cooling outlet. The lower part of the pump refers to a side that is of the pump and that is close to the liquid cooling part in the thickness direction. In an implementation, an orthographic projection, on the second flexible film, of the first sub-rigid substrate does not overlap an orthographic projection, on the second flexible film, of an area enclosed by an edge of the pump liquid inlet and an edge of the pump liquid outlet. In an implementation, for ease of processing or for better separation of runners on the two sides of the pump through the first sub-rigid substrate, the first sub-rigid substrate may extend slightly outside of the pump. The second rigid substrate is mainly configured to separate the liquid inlet runner and the liquid outlet runner. However, the second rigid substrate cannot cause obstruction to the cooling medium entering and exiting the pump cavity. Therefore, in this solution, the orthographic projection, on the second flexible film, of the first sub-rigid substrate does not overlap the orthographic projection, on the second flexible film, of the area enclosed by the edge of the liquid cooling inlet and the edge of the liquid cooling outlet. This can reduce flow resistance of the cooling medium when the cooling medium passes through the liquid cooling inlet and the liquid cooling outlet.

In an implementation, the first sub-rigid substrate and the first rigid substrate are made of a same material. The first sub-rigid substrate is positioned below the pump. In this case, a cooling liquid pumped out by the pump during working has impact pressure on the first sub-rigid substrate when entering or exiting the liquid cooling inlet and the liquid cooling outlet. This leads the system performance to rapidly decrease and become invalid. The first sub-rigid substrate and the first rigid substrate are made of a same material, so that a sealing effect and structural strength between the first sub-rigid substrate and both the first flexible film and the second flexible film are the same as a sealing effect and structural strength between the first rigid substrate and both the first flexible film and the second flexible film, thereby effectively improving the sealing effect and structural strength between the first sub-rigid substrate and both the first flexible film and the second flexible film, and avoiding impact on the sealing effect due to impact of a liquid near the pump on the first sub-rigid substrate.

In an implementation, the first sub-rigid substrate and the first rigid substrate are of an integrated structure, thereby improving sealing performance and reliability between the first sub-rigid substrate and the first rigid substrate. In an implementation, the first sub-rigid substrate and the second sub-rigid substrate are of an integrated structure. This improves sealing performance and reliability between the first sub-rigid substrate and the second sub-rigid substrate.

In an implementation, hot-pressing welding is simultaneously performed on the first sub-rigid substrate, the first rigid substrate, and the first flexible film, or the second flexible film. In this solution, a sealing effect and structural strength between the first sub-rigid substrate and the first flexible film or the second flexible film can be improved.

In an implementation, the second rigid substrate is integrally bar-shaped. In this solution, processing costs can be reduced, and a regular shape of the second rigid substrate helps reduce flow resistance generated by the second rigid substrate on the cooling medium.

In an implementation, an integrated sealing structure is provided between the first flexible film that is disposed corresponding to the second rigid substrate in the thickness direction and the pump bottom wall. This solution can further ensure that the cooling medium in the liquid inlet runner and the liquid outlet runner does not have a short-circuit and mixed flow.

In an implementation, the liquid cooling part further includes a third rigid substrate, the third rigid substrate is distributed in the liquid inlet runner and the liquid outlet runner, and two ends of the third rigid substrate, and the first flexible film and the second flexible film are of an integrated sealing structure. If leakage occurs in separating and sealing between the third rigid substrate and both the first flexible film and the second flexible film, performance of the liquid cooling system slightly decreases, but the entire liquid cooling system does not become invalid.

In this implementation, a plurality of third rigid substrates separate the liquid inlet runner into a plurality of liquid inlet sub-runners that communicate with each other, and separate the liquid outlet runner into a plurality of liquid outlet sub-runners that communicate with each other. The third rigid substrates respectively achieve a flow guide function in the liquid inlet runner and the liquid outlet runner, thereby reducing flow resistance and avoiding an eddy flow loss, and helping enhance a heat exchange effect of the cooling medium. The third rigid substrate may be integrally bar-shaped or cylindrical. The third rigid substrate in a bar shape helps guide flow of the cooling medium, and the third rigid substrate in a cylindrical shape helps strengthen mixing of the cooling medium.

In an implementation, because the third rigid substrate has a function of simultaneously guiding and mixing flow, the third rigid substrate may be disposed in an area in which a width of the liquid inlet runner or the liquid outlet runner is suddenly changed, an area in which a flow direction of the cooling medium is suddenly changed, and an area adjacent to the liquid cooling inlet.

In this implementation, there are discontinuous interfaces among the two ends of the third rigid substrate, the first flexible film, and the second flexible film. In an implementation, the two ends of the third rigid substrate, at least a part of the first flexible film and at least a part of the second flexible film are continuously integrated, to form an integrated sealing structure. In another implementation, the two ends of the third rigid substrate, the first flexible film, and the second flexible film are all continuously integrated into an integrated sealing structure, there is no interface between the two ends of the third rigid substrate and the first flexible film, and there is no interface between the two ends of the second rigid substrate and the second flexible film. This can further help improve a sealing effect.

In an implementation, a thickness of the first rigid substrate, a thickness of the second rigid substrate, and a thickness of the third rigid substrate are all less than a width of the liquid cooling module. Specifically, a ratio range of each of the thickness of the first rigid substrate, the thickness of the second rigid substrate, and the thickness of the third rigid substrate to the width of the liquid cooling module is greater than or equal to 0.1 and less than or equal to 0.2. The thickness of the first rigid substrate, the thickness of the second rigid substrate, and the thickness of the third rigid substrate are all less than a length of the liquid cooling module. Specifically, a ratio range of each of the thickness of the first rigid substrate, the thickness of the second rigid substrate, and the thickness of the third rigid substrate to the length of the liquid cooling module is greater than or equal to 10 to 5 and less than or equal to 0.2. This solution helps ensure high strength of the liquid cooling module in the thickness direction and flexibility of the liquid cooling module in a length direction and a width direction.

In an implementation, the thickness of the first rigid substrate, the thickness of the second rigid substrate, and the thickness of the third rigid substrate are unequal. The thickness is a size in the thickness direction. In this implementation, the three rigid substrates are in an unequal-thickness design. When the liquid cooling module is used in a foldable device, space in the foldable device is fully utilized, and other components in the device are avoided, so that a layout is optimized.

In an implementation, the first flexible film or the second flexible film may be further provided with a liquid injection opening, a gas extraction opening, and the like. The liquid injection opening and the gas extraction opening, at least one of the three rigid substrates, and the first flexible film or the second flexible film are of an integrated sealing structure. In this implementation, the liquid injection opening is configured to inject the cooling medium into the inner cavity before cooling, and the gas extraction opening is configured to extract gas from the inner cavity, to avoid negative impact on a heat dissipation effect. The liquid injection opening and the gas extraction opening are integrally sealed and connected to at least one of the first rigid substrate, the second rigid substrate, and the third rigid substrate, and the first flexible film or the second flexible film. This helps avoid leakage of the cooling medium in the liquid injection opening and the gas extraction opening. To achieve an ultra-thin effect, the liquid injection opening, the gas extraction opening, and the liquid cooling part are on a same plane, that is, between the first flexible film and the second flexible film.

In an implementation, the liquid cooling part includes a liquid cooling film bending area, the liquid cooling part is folded through the liquid cooling film bending area, at least one of the first rigid substrate, the second rigid substrate, and the third rigid substrate is provided with the flexibility-enhancement structure, the flexibility-enhancement structure is located in the liquid cooling film bending area, and the flexibility-enhancement structure is configured to enhance flexibility of the liquid cooling film bending area.

In this implementation, the first rigid substrate, the second rigid substrate, and the third rigid substrate can enhance strength of the liquid cooling part in the thickness direction because of rigidity. When the liquid cooling part is used in the foldable device, and a bendable part of the liquid cooling part needs to have specific flexibility. In this solution, the flexibility-enhancement structure is disposed in the liquid cooling film bending area of the liquid cooling part. This can reduce resistance to the bendable part of the liquid cooling part during bending, and can meet a folding requirement of the electronic device.

In an implementation, the flexibility-enhancement structure may be at least one of a groove, a penetration hole, a through hole, and an opening.

In an implementation, the liquid cooling part further includes a first liquid cooling film static area and a second liquid cooling film static area that are located on two sides of the liquid cooling film bending area. When bending in the liquid cooling film bending area is performed, the first liquid cooling film static area and the second liquid cooling film static area do not deform.

In an implementation, the flexibility-enhancement structure of the first rigid substrate includes a groove located on a side wall of the first rigid substrate, and the groove is located in the liquid cooling film bending area.

In this implementation, the first rigid substrate is disposed around an edge of the liquid cooling module, and is a barrier between the cooling medium and an external environment. Therefore, the first rigid substrate needs to have high structural strength, to ensure a sealing effect, so that the cooling medium does not leak to the outside of the liquid cooling module. However, the first rigid substrate located in the liquid cooling film bending area needs to consider both structural strength and specific flexibility. Therefore, the flexibility-enhancement structure disposed on the first rigid substrate is preferably the groove. If a penetration hole, a through hole, or an opening is provided on the first rigid substrate, there is a leakage risk of the cooling medium.

In an implementation, the flexibility-enhancement structure of the second rigid substrate includes a through hole that penetrates the second rigid substrate in a first direction, the through hole is located in the liquid cooling film bending area, and the first direction is an arrangement direction of the first flexible film and the second flexible film.

In this implementation, the through hole is provided in the second rigid substrate, so that flexibility of the bendable part of the second rigid substrate can be enhanced. Because two sides of the second rigid substrate are respectively provided with the liquid inlet runner and the liquid outlet runner, communication of the cooling medium on the two sides cannot be achieved through an opening on the second rigid substrate, to avoid affecting a cooling effect due to mixed flow. The first direction A is also the thickness direction of the liquid cooling part.

In an implementation, the liquid cooling part is provided with a penetration hole that penetrates the second rigid substrate, the first flexible film, and the second flexible film in the first direction, and the penetration hole is located in the liquid cooling film bending area.

In this implementation, the penetration hole is provided in the second rigid substrate, so that flexibility of the bendable part of the second rigid substrate can be enhanced, and a rebound force and a friction force of a bending area of the liquid cooling part during bending can be reduced. The first direction is the thickness direction of the liquid cooling module. The penetration hole penetrates the second rigid substrate in the first direction, so that a flow short-circuit and mixed flow of the cooling medium in the liquid inlet runner and the liquid outlet runner are not caused. The third rigid substrate may be provided with an opening, to reduce a rebound force of the bending area of the liquid cooling part and a friction force between the bending area of the liquid cooling part and each of a screen, and a middle frame during bending, and avoid a flow short-circuit of the cooling medium.

In an implementation, the flexibility-enhancement structure of the second rigid substrate includes the through hole and the penetration hole, or the flexibility-enhancement structure of the second rigid substrate includes either of the through hole and the penetration hole. In this solution, the through hole and the penetration hole may be flexibly provided in the second rigid substrate based on an actual situation, to improve practicability of the second rigid substrate in different application environments.

In an implementation, the flexibility-enhancement structure of the third rigid substrate includes the opening located on the third rigid substrate, and runners on two sides of the third rigid substrate communicate with each other through the opening.

In this implementation, because the liquid cooling film bending area generates large deformation during bending, in this solution, that the third rigid substrate is provided with the opening means that the third rigid substrate is partially disconnected at the opening, thereby inducing bending deformation at a designed position, and effectively reducing stress generated during bending. A part of the third rigid substrate is distributed in the liquid inlet runner, and a part of the third rigid substrate is distributed in the liquid outlet runner, that is, the runners on the two sides of the third rigid substrate belong to the liquid inlet runner or the liquid outlet runner. Therefore, communication between the two sides of the third rigid substrate through the opening does not affect heat dissipation efficiency, and a mixed-flow effect of the cooling medium in a same flow direction in the liquid inlet runner or the liquid outlet runner can be improved, thereby improving a cooling effect.

In an implementation, the flexibility-enhancement structure may extend in a flow direction of the cooling medium. In another implementation, the flexibility-enhancement structure may extend in a folding direction of the foldable device. A size of the flexibility-enhancement structure is set to be large in the extension direction, so that flexibility of the liquid cooling film bending area can be effectively enhanced, and a rebound force of the bending area of the liquid cooling part and a friction force between the bending area of the liquid cooling part and each of the screen, and the middle frame during bending can be reduced. Further, user experience of the foldable device is improved.

In an implementation, a lubricating material layer is laid on a surface that is of each of the first flexible film and the second flexible film and that is away from the inner cavity, and the lubricating material layer is located in the liquid cooling film bending area. In this implementation, to enhance flexibility of the liquid cooling film bending area, in addition to disposing the flexibility-enhancement structures on the first rigid substrate, the second rigid substrate, and the third rigid substrate, the lubricating material layers may be further disposed on outer surfaces of the first flexible film and the second flexible film, to reduce a friction force during bending of the liquid cooling film bending area, so that a bending process can be more smoothly performed. For example, the lubricating material layer includes but is not limited to a solid-state, liquid-state, or paste-like lubricating material like a Teflon film, a graphite film, a graphene film, or lubricating grease. When the graphite film or the graphene film is used as the lubricating material layer, the lubricating material layer may be disposed in only the liquid cooling film bending area, or may be disposed in the liquid cooling film bending area and at least one of the first liquid cooling film static area and the second liquid cooling film static area. In this case, in addition to having a lubricating and friction reduction function on the liquid cooling film static area, the lubricating material layer can further enhance a heat dissipation effect and reduce an overall temperature of the cooling medium because of a high thermal conductivity coefficient of graphite and graphene, so that start time and a start frequency of the pump are reduced.

According to a second aspect, this application provides a liquid cooling part, where the liquid cooling part includes a first flexible film, a second flexible film, and a first rigid substrate located between the first flexible film and the second flexible film, the first flexible film, the second flexible film, and the first rigid substrate enclose an inner cavity of the liquid cooling part, and a difference between a glass transition temperature a material of the first rigid substrate and a glass transition temperature of a material of the first flexible film is less than or equal to 20°C.

In this implementation, the first flexible film and the second flexible film can reduce bending difficulty of an electronic device. The first rigid substrate is configured to enhance structural strength of the liquid cooling part in a thickness direction. The first flexible film, the second flexible film, and the first rigid substrate enclose the inner cavity, a cooling medium flows in the inner cavity, and two ends of the first rigid substrate, the first flexible film, and the second flexible film are of an integrated sealing structure. This helps improve sealing performance of the first rigid substrate and avoid leakage of the cooling medium.

In this implementation, the difference between the glass transition temperature of the material of the first rigid substrate and the glass transition temperature of the material of the first flexible film is set to a small value, so that the first rigid substrate and the first flexible film are sealed into an integrated structure through thermo compression bonding, thereby improving a sealing effect between the first rigid substrate and the first flexible film.

In an implementation, a difference between a melting temperature of a material of the first rigid substrate and a melting temperature of a material of the first flexible film is less than or equal to 20°C. In this implementation, the difference between the melting temperature of the material of the first rigid substrate and the melting temperature of the material of the first flexible film is set to a small value, so that the first rigid substrate and the first flexible film are sealed into an integrated structure through thermo compression bonding, thereby improving a sealing effect between the first rigid substrate and the first flexible film.

According to a third aspect, this application provides a liquid cooling part, where the liquid cooling part includes a first flexible film, a second flexible film, and a first rigid substrate located between the first flexible film and the second flexible film, the first flexible film, the second flexible film, and the first rigid substrate enclose an inner cavity of the liquid cooling part, a material of each of the first flexible film, the second flexible film, and the first rigid substrate is a flexible temperature-resistant polymer material with elongation at break greater than 10%, and materials of the first flexible film, the second flexible film, and the first rigid substrate are independently selected from at least one of a polyethylene terephthalate copolymer, polyethylene naphthalate, polyethylene 2,5-furandicarboxylate, polyimide, polyetheretherketone, and biaxially oriented polypropylene.

In this implementation, the first flexible film and the second flexible film can reduce bending difficulty of an electronic device. The first rigid substrate is configured to enhance structural strength of the liquid cooling part in a thickness direction. The first flexible film, the second flexible film, and the first rigid substrate enclose the inner cavity, a cooling medium flows in the inner cavity, and two ends of the first rigid substrate, the first flexible film, and the second flexible film are of an integrated sealing structure. This helps improve sealing performance of the first rigid substrate and avoid leakage of the cooling medium.

In this implementation, materials selected by the first rigid substrate and the first flexible film or the second flexible film help form an integrated sealing structure between the first rigid substrate and the first flexible film or the second flexible film through hot pressing. The first rigid substrate and the first flexible film or the second flexible film may be made of different materials, provided that an integrated sealing structure can be formed between the first rigid substrate and the first flexible film or the second flexible film.

According to a fourth aspect, this application provides a liquid cooling part, where the liquid cooling part includes a first flexible film, a second flexible film, and a rigid substrate located between the first flexible film and the second flexible film. The liquid cooling part includes a liquid cooling film bending area, the liquid cooling part is folded through the liquid cooling film bending area, the rigid substrate is provided with a flexibility-enhancement structure, the flexibility-enhancement structure is located in the liquid cooling film bending area, and the flexibility-enhancement structure is configured to enhance flexibility of the liquid cooling film bending area.

In this implementation, two ends of the rigid substrate are configured to support the first flexible film and the second flexible film, and disposing the rigid substrate in the liquid cooling part helps improve structural strength of the liquid cooling part in a thickness direction. When an electronic device is bent, large deformation occurs in the liquid cooling film bending area in the liquid cooling part. Therefore, the flexibility-enhancement structure needs to be disposed on the rigid substrate located in the liquid cooling film bending area, to enhance flexibility of the liquid cooling film bending area. In an implementation, the flexibility-enhancement structure may be at least one of a groove, a penetration hole, a through hole, and an opening. In an implementation, the rigid substrate may include a first rigid substrate, a second rigid substrate, and a third rigid substrate.

According to a fifth aspect, this application provides an electronic device, where the electronic device includes the liquid cooling module according to any one of the implementations of the first aspect, and the liquid cooling module is located in the electronic device. In an implementation, the liquid cooling module is located in an accessory of the electronic device. In an implementation, the electronic device includes the liquid cooling part according to any one of the second aspect, the third aspect, and the fourth aspect, and the liquid cooling part is located in the electronic device. In an implementation, the liquid cooling module is located in an accessory of the electronic device.

In an implementation, the electronic device includes a first non-folding part, a folding part, and a second non-folding part, the second non-folding part is foldable toward the first non-folding part through the folding part, the liquid cooling part includes the liquid cooling film bending area, when the electronic device is folded, the liquid cooling part is folded through the liquid cooling film bending area, at least one of the first rigid substrate, the second rigid substrate, and the third rigid substrate is provided with a flexibility-enhancement structure, the flexibility-enhancement structure is located in the liquid cooling film bending area, and the flexibility-enhancement structure is configured to enhance flexibility of the liquid cooling film bending area.

Beneficial effects of this application: On a foldable electronic device, an equivalent thermal conductivity coefficient of the liquid cooling module may be more than 5000 W/m-K, and a heat dissipation capability of the liquid cooling module is improved by more than 100% compared with that of a cross-axis/through-axis graphite heat dissipation material. In this way, a liquid cooling system is simplified in processing and manufacturing, has no assembly leakage, and has high flexibility.

### BRIEF DESCRIPTION OF DRAWINGS

To describe technical solutions in embodiments of this application more clearly, the following describes the accompanying drawings used in embodiments of this application.
FIG. 1a is a diagram of a structure of a liquid cooling module according to a first embodiment of this application;
FIG. 1b is a partially enlarged view of a part P in FIG. 1a;
FIG. 1c is a physical diagram of a pump part of the liquid cooling module according to the first embodiment of this application;
FIG. 2 is a sectional view of the liquid cooling module according to the first embodiment of this application;
FIG. 3 is a sectional view of the liquid cooling module according to the first embodiment of this application;
FIG. 4 is a top view of the liquid cooling module according to the first embodiment of this application;
FIG. 5 is a sectional view of the liquid cooling module according to the first embodiment of this application;
FIG. 6 is a sectional view of the liquid cooling module according to the first embodiment of this application;
FIG. 7 is an exploded view of a stacked structure of the pump part according to the first embodiment of this application;
FIG. 8 is a sectional view of the liquid cooling module according to the first embodiment of this application;
FIG. 9 is a sectional view of the liquid cooling module according to the first embodiment of this application;
FIG. 10 is a side view of a pump and a second rigid substrate according to the first embodiment of this application;
FIG. 11 is a sectional view of a liquid cooling part according to the first embodiment of this application;
FIG. 12 is a sectional view of the liquid cooling part according to the first embodiment of this application;
FIG. 13 is a sectional view of a first flexible film according to the first embodiment of this application;
FIG. 14 is a sectional view of the liquid cooling part according to the first embodiment of this application;
FIG. 15 is a partially enlarged view of the liquid cooling module shown in FIG. 1a;
FIG. 16 is a sectional view of the liquid cooling part according to the first embodiment of this application;
FIG. 17 is a sectional view of the liquid cooling part according to the first embodiment of this application;
FIG. 18 is a sectional view of the liquid cooling part according to the first embodiment of this application;
FIG. 19 is a sectional view of the liquid cooling part according to the first embodiment of this application;
FIG. 20 is a diagram of a structure of an electronic device according to the first embodiment of this application;
FIG. 21 is a diagram of a structure of an electronic device according to a second embodiment of this application;
FIG. 22 is a diagram of the structure of the electronic device according to the second embodiment of this application;
FIG. 23 is a diagram of a structure of an electronic device according to a third embodiment of this application;
FIG. 24 is a diagram of a partial structure of a liquid cooling module according to the third embodiment of this application;
FIG. 25 is a diagram of structures of the liquid cooling module and a flexible circuit board according to the third embodiment of this application;
FIG. 26 is a diagram of a structure of a liquid cooling module according to a fourth embodiment of this application;
FIG. 27 is a diagram of the structure of the electronic device according to the first embodiment of this application;
FIG. 28 is a diagram of a structure of an electronic device according to a fifth embodiment of this application; and
FIG. 29 is a diagram of the liquid cooling module according to the first embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms "first", "second", and the like in this specification are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this specification, orientation terms such as "upper" and "lower" are defined relative to orientations of schematically disposed structures in the accompanying drawings. It should be understood that these directional terms are relative concepts and are used for relative description and clarification, and may vary accordingly with changes of the orientations of the structures.

For ease of understanding, the following first explains and describes English abbreviations and related technical terms in embodiments of this application.

PET is polyethylene terephthalate (polyethylene terephthalate).

A glass transition temperature is a temperature corresponding to transition from a glass state to a high-elastic state. A higher glass transition temperature indicates better heat resistance of a material.

Embodiments of this application provide a liquid cooling module, where the liquid cooling module includes a pump and a liquid cooling part, the pump is configured to provide power for a cooling medium in the liquid cooling part, the pump includes a pump base and a piezoelectric component, and the pump base is provided with a pump liquid inlet and a pump liquid outlet. The liquid cooling part includes a liquid cooling outlet and a liquid cooling inlet. The liquid cooling outlet communicates with the pump liquid inlet, the liquid cooling inlet communicates with the pump liquid outlet, and a part of the liquid cooling part on a periphery of the liquid cooling outlet and a part of the pump base on a periphery of the pump liquid inlet are made of a same material or similar materials, and are of an integrated sealing and welding structure without solder paste or another third material; and a part of the liquid cooling part on a periphery of the liquid cooling inlet and a part of the pump base on a periphery of the pump liquid outlet are made of a same material or similar materials, and are of an integrated sealing and welding structure without solder paste or another third material. The integrated sealing welding manner includes a welding manner without solder paste or another third material, for example, thermo compression bonding and seal welding, thermo melt welding, ultrasonic welding, or high frequency welding. The liquid cooling part includes a first flexible film (with elongation at break>10%), a second flexible film (with elongation at break>10%), a first rigid substrate, a second rigid substrate, a third rigid substrate, and the like. The first rigid substrate and the second rigid substrate have a same material or similar materials as the first flexible film and the second flexible film, and an integrated sealing and welding structure without solder paste or another third material is used to seal the first rigid substrate and the second rigid substrate, and the first flexible film and the second flexible film. The integrated sealing welding manner includes a welding manner without solder paste or another third material, for example, thermo compression bonding and seal welding, thermo melt welding, ultrasonic welding, or high frequency welding. In the liquid cooling module provided in embodiments of this application, the pump, the liquid cooling part, and the interior of the liquid cooling part are integrally welded and sealed, and no assembly leakage occurs, so that the liquid cooling module is resistant to bending and impact, adapts to changes and fluctuations in system pressure and a volume, is simplified in design and manufacturing, and can avoid cooling medium leakage caused by a sealing problem. In this way, stability of an overall structure of the liquid cooling module and safety performance of an electronic device are improved.

The following describes in detail the liquid cooling module provided in embodiments of this application.

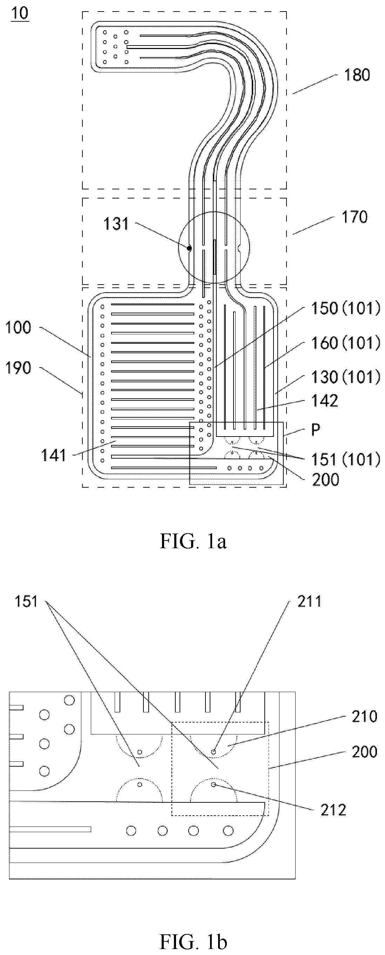

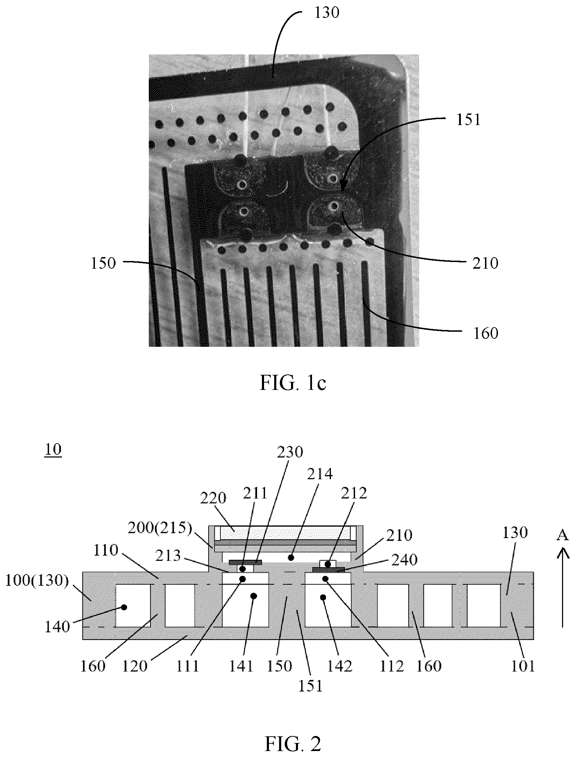

Refer to FIG. 1a, FIG. 1b, FIG. 1c, and FIG. 2. FIG. 1a is a diagram of a structure of a liquid cooling module 10 according to a first embodiment of this application; FIG. 1b is a partially enlarged view of a part P in FIG. 1a; FIG. 1c is a physical diagram of a pump part of the liquid cooling module according to the first embodiment of this application; and FIG. 2 is a sectional view of the liquid cooling module 10 according to the first embodiment of this application.

In an implementation, the liquid cooling module 10 includes a pump 200 and a liquid cooling part 100 (as shown in FIG. 1a and FIG. 2). The pump 200 includes a pump base 210, a piezoelectric component 220, and the like. The pump base 210 is provided with a pump liquid inlet 211 and a pump liquid outlet 212 (as shown in FIG. 2). The liquid cooling part 100 includes a liquid cooling outlet 111 and a liquid cooling inlet 112 (as shown in FIG. 2). The liquid cooling outlet 111 is configured to communicate with the pump liquid inlet 211, and the liquid cooling inlet 112 is configured to communicate with the pump liquid outlet 212. A part of the liquid cooling part 100 on a periphery of the liquid cooling outlet 111 and a part of the pump base 210 on a periphery of the pump liquid inlet 211 are of an integrated sealing structure (as shown in FIG. 2). A part of the liquid cooling part 100 on a periphery of the liquid cooling inlet 112 and a part of the pump base 210 on a periphery of the pump liquid outlet 212 are of an integrated sealing structure (as shown in FIG. 2). In engineering, glue dispensing can be used for the pump and the liquid cooling part to enhance structural positioning and strength but not to seal a welding surface.

The pump 200, as a power source of the liquid cooling module 10, can provide flowing and circulating power for a cooling medium in the liquid cooling part 100, to implement active liquid cooling, thereby achieving an effect of persistent heat dissipation. Compared with passive liquid cooling, active liquid cooling can achieve an optimal heat dissipation effect through adjustment on a speed of the pump 200 as required, while passive liquid cooling can implement only passive heat dissipation based on a temperature change of a component. Therefore, active liquid cooling has better adjustment performance. It should be noted that, that the liquid cooling outlet 111 is configured to communicate with the pump liquid inlet 211 does not mean that the liquid cooling outlet 111 is always in a communication state with the pump liquid inlet 211, but means that the cooling medium can flow into the pump liquid inlet 211 from the liquid cooling outlet 111 under a specific condition. A relationship between the liquid cooling inlet 112 and the pump liquid outlet 212 is similar to that described above.

In this implementation, the part of the liquid cooling part 100 on the periphery of the liquid cooling outlet 111 and the part of the pump base 210 on the periphery of the pump liquid inlet 211 are of the integrated sealing structure, and the part of the liquid cooling part 100 on the periphery of the liquid cooling inlet 112 and the part of the pump base 210 on the periphery of the pump liquid outlet 212 are of the integrated sealing structure. The forming the integrated sealing structure means that there are no continuous interfaces between two parts because of mutual integration and penetration, and the periphery of the liquid cooling outlet 111 is an adjacent area around the liquid cooling outlet 111. If the liquid cooling part 100 and the pump base 210 are fastened in a screw connection manner, because the liquid cooling part 100 and the pump base 210 are separated components, a boundary between the liquid cooling part 100 and the pump base 210 is continuous. Compared with a structure made in a screw fastening manner, the integrated sealing structure in embodiments of this application cannot be separated in general cases unless the integrated sealing structure is damaged by applying an external force. However, as the screw connection manner is adopted, the pump base 210 and the liquid cooling part 100 can be separated by only removing screws.

In the fastening manner through screw connection, because a tightness degree (namely, a sealing effect) of the screw connection is limited by a plurality of factors such as assembly precision and a resilient force of a material, quality control is inconvenient, and the cooling medium may leak during actual use, thereby affecting heat dissipation efficiency of the cooling medium and damaging an internal component. In addition, a base usually needs to be disposed in the pump 200, and a screw passes through the base and the liquid cooling part 100 in sequence to implement fastening. However, according to the integrated sealing structure in embodiments of this application, the part of the liquid cooling part 100 on the periphery of the liquid cooling outlet 111 is integrated with the part of the pump base 210 on the periphery of the pump liquid inlet 211, so that a connection relationship is closer. This helps improve a sealing effect between the pump base 210 and the liquid cooling part 100, and an additional base is not required, thereby simplifying a structure of the liquid cooling module 10, reducing costs and processing difficulty, and achieving an ultra-thin design. In addition, the liquid cooling module 10 provided in embodiments of this application may be used in an electronic device. When the electronic device is subject to an external force (for example, when the electronic device falls to the ground and collides with the ground), the screw fastening manner may cause the pump base 210 and the liquid cooling part 100 to be connected loosely or not partially sealed tightly due to offset of an O-shaped ring. However, the pump base 210 and the liquid cooling part 100 are unlikely to have relative displacement because of the integrated sealing structure, thereby improving stability of an overall structure of the liquid cooling module 10 and prolonging a service life of the electronic device.

In this application, the liquid cooling module 10 is disposed as follows: First, the pump 200 is configured to provide flowing and circulating power for the cooling medium, to implement active heat dissipation in the liquid cooling module 10. Compared with passive liquid cooling active liquid cooling can reduce a temperature of a component more effectively, and improve heat dissipation efficiency.

Second, an area of the liquid cooling part 100 on the periphery of the liquid cooling outlet 111 and an area of the pump base 210 on the periphery of the pump liquid inlet 211 are of an integrated sealing structure, and an area of the liquid cooling part 100 on the periphery of the liquid cooling inlet 112 and an area of the pump base 210 on the periphery of the pump liquid outlet 212 are of an integrated sealing structure. Compared with the structure made in the screw fastening manner, the integrated sealing structure has a better sealing effect, and can prevent the cooling medium from leaking, thereby avoiding reducing heat dissipation efficiency of the cooling medium, and protecting components from being damaged.

In an implementation, centers of the liquid cooling outlet 111 and the pump liquid inlet 211 are aligned in a thickness direction A of the liquid cooling module 10, and projections of areas enclosed by circumferential walls of the liquid cooling outlet 111 and the pump liquid inlet 211 overlap in the thickness direction A. This solution helps reduce flow resistance of the cooling medium when the cooling medium passes through the liquid cooling outlet 111 and the pump liquid inlet 211, and improve cooling efficiency.

In an implementation, centers of the liquid cooling inlet 112 and the pump liquid outlet 212 are aligned in the thickness direction A of the liquid cooling module 10, and projections of areas enclosed by circumferential walls of the liquid cooling inlet 112 and the pump liquid outlet 212 overlap in the thickness direction A. This solution helps reduce flow resistance of the cooling medium when the cooling medium passes through the liquid cooling inlet 112 and the pump liquid outlet 212, and improve cooling efficiency.

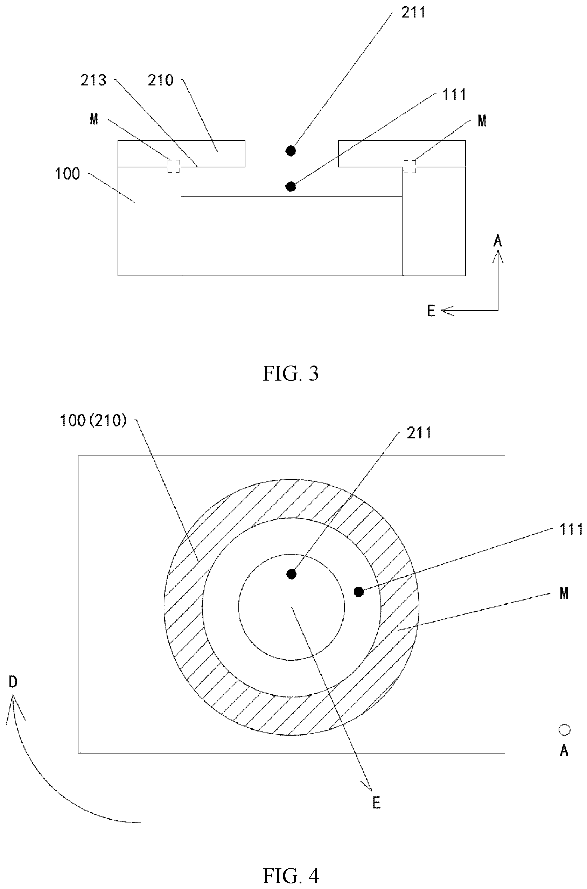

Refer to FIG. 3 and FIG. 4. FIG. 3 is a sectional view of the liquid cooling module 10 according to the first embodiment of this application; and FIG. 4 is a top view of the liquid cooling module 10 according to the first embodiment of this application. In an implementation, at least a part of the part of the liquid cooling part 100 on the periphery of the liquid cooling outlet 111 and at least a part of the part of the pump base 210 on the periphery of the pump liquid inlet 211 are continuously integrated in a circumferential direction D of the liquid cooling outlet 111 (as shown in FIG. 3 and FIG. 4), to form an integrated sealing structure.

In this implementation, to ensure a sealing effect between the pump base 210 and the liquid cooling part 100, the integrated sealing structure needs to be continuously integrated into an integrated sealing structure M in the circumferential direction of the liquid cooling outlet 111, as shown in a ring-shaped shadow area in FIG. 4. In an implementation, a shape of the M may be an ellipse, a square, a triangle, or an irregular pattern. In an implementation, an integrated sealing structure is formed on the periphery of the liquid cooling outlet 111 in a radial direction E. It should be noted that, an integrated sealing and welding structure that is continuously integrated and that have no third material may be disposed in the circumferential direction D only at one or more positions on the periphery of the liquid cooling outlet 111.

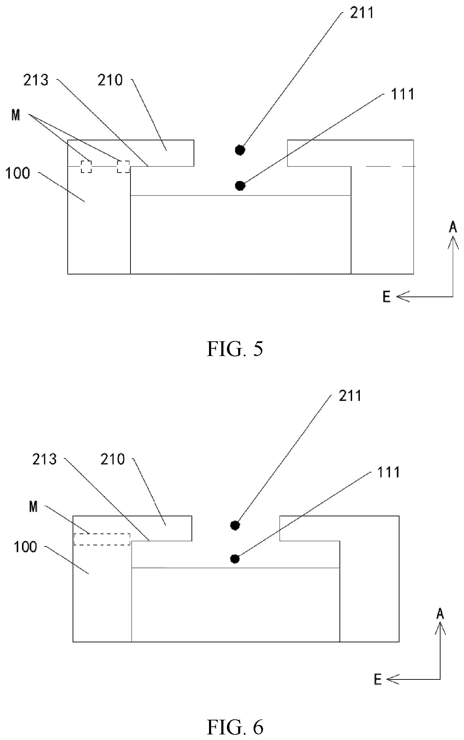

Refer to FIG. 3, FIG. 5, and FIG. 6. FIG. 5 is a sectional view of the liquid cooling module 10 according to the first embodiment of this application; and FIG. 6 is a sectional view of the liquid cooling module 10 according to the first embodiment of this application. In an implementation, in the radial direction E of the liquid cooling outlet 111, there may be discontinuous interfaces between the part of the liquid cooling part 100 on the periphery of the liquid cooling outlet 111 and the part of the pump base 210 on the periphery of the pump liquid inlet 211. In addition, a spacing between the interfaces is not limited (as shown in FIG. 3 and FIG. 5), where there is an integrated sealing structure at a position without an interface. In a preferred implementation, in the radial direction E of the liquid cooling outlet 111, no interface is formed between the part of the liquid cooling part 100 on the periphery of the liquid cooling outlet 111 and the part of the pump base 210 on the periphery of the pump liquid inlet 211 (as shown in FIG. 6), which is a preferred processing process with a best sealing effect.

It may be understood that, in the liquid cooling module 10 shown in FIG. 3 to FIG. 6, the radial direction E and the circumferential direction D are determined based on a circular shape of the liquid cooling outlet 111. When the liquid cooling outlet 111 is in another shape, the radial direction E may be understood as a direction from a center of the liquid cooling outlet 111 to a position on a periphery.

In an implementation, at least a part of the part of liquid cooling part 100 on the periphery of the liquid cooling inlet 112 and at least a part of the part of the pump base 210 on the periphery of the pump liquid outlet 212 are continuously integrated in a circumferential direction of the liquid cooling inlet 112, to form an integrated sealing structure. In this solution, the integrated sealing structure on the periphery of the liquid cooling inlet 112 is continuously integrated in the circumferential direction of the liquid cooling inlet 112.

Still refer to FIG. 2. In an implementation, the pump 200 further includes a piezoelectric component 220. The piezoelectric component 220 is fastened to the pump base 210, the pump base 210 includes a pump bottom wall 213, the pump bottom wall 213, the piezoelectric component 220, and a part of the pump base 210 between the pump bottom wall 213 and the piezoelectric component 220 enclose a pump cavity 214. The pump liquid inlet 211 and the pump liquid outlet 212 are disposed on the pump bottom wall 213 and communicate with the pump cavity 214, the pump bottom wall 213, a part of the liquid cooling part 100 on the periphery of the liquid cooling outlet 111, and a part of the liquid cooling part 100 on the periphery of the liquid cooling inlet 112 are of an integrated sealing structure.

The piezoelectric component 220 uses an inverse piezoelectric effect of a piezoelectric material. The piezoelectric material is a crystal material that generates a voltage between two end surfaces under pressure. The inverse piezoelectric effect means that after an electric field is applied to the piezoelectric component 220, mechanical deformation or mechanical pressure is generated in a specific direction on the piezoelectric component 220. When the applied electric field is removed, the deformation or stress disappears accordingly. The piezoelectric component 220 is disposed in the pump 200, and has characteristics of a small size, high energy density, no electromagnetic interference, and the like, to implement precise transmission and control of a cooling medium. In an implementation, the piezoelectric component 220 includes a piezoelectric ceramic, a metal substrate, a plastic spacer (a metal substrate that prevents a liquid working medium from corrosion), and the like.

In this implementation, a communication relationship between the pump liquid inlet 211 and the pump cavity 214 is similar to a communication relationship between the liquid cooling outlet 111 and the pump liquid inlet 211. That is, the pump liquid inlet 211 and the pump cavity 214 are not always in communication, but under driving of the piezoelectric component 220, the cooling medium enters the pump cavity 214 through the liquid cooling outlet 111 and the pump liquid inlet 211. A communication relationship between the pump liquid outlet 212 and the pump cavity 214 is similar to that described above. In this implementation, both the pump liquid inlet 211 and the pump liquid outlet 212 are disposed on the pump bottom wall 213, and a part of the pump bottom wall 213 on the periphery of the pump liquid inlet 21, a part of the pump bottom wall 213 on the periphery of the pump liquid outlet 212, and a part of the liquid cooling part 100 are of an integrated sealing structure, that is, no base needs to be additionally disposed in the pump 200. If a base is disposed in the pump 200, the base can be fastened to the liquid cooling part 100 through only a screw, and consequently, a sealing effect is poor, and the cooling medium is prone to leakage. In addition, the pump liquid inlet 211 and the pump liquid outlet 212 usually need to be disposed outside the base, so that a circulation path of the cooling medium is extended, and heat dissipation efficiency of the cooling medium is reduced.

Still refer to FIG. 1a. In this implementation, the liquid cooling module 10 includes two pumps 200 connected in parallel, and the two pumps 200 connected in parallel can implement a larger flow volume. In another implementation, the liquid cooling module 10 includes two pumps 200 connected in series, and the two pumps 200 connected in series can implement larger drive pressure. In another implementation, the liquid cooling module 10 may include a plurality of pumps 200, and the plurality of pumps 200 may be distributed at different positions in the liquid cooling module 10, and may be specifically disposed as required.

Still refer to FIG. 2. In an implementation, the pump 200 further includes a liquid inlet valve film 230 and a liquid outlet valve film 240 that are fastened to the pump bottom wall 213. The liquid inlet valve film 230 is configured to close or open the pump liquid inlet 211, and the liquid outlet valve film 240 is configured to close or open the pump liquid outlet 212. In this implementation, in a liquid inlet scenario, the piezoelectric component 220 is configured to: generate deformation after receiving an electrical signal, increase a volume of the pump cavity 214, drive the liquid inlet valve film 230 to open and the liquid outlet valve film 240 to close, and provide power for the cooling medium in the liquid cooling part 100, so that the cooling medium enters the pump cavity 214 through the liquid cooling outlet 111 and the pump liquid inlet 211 in sequence. In a liquid outlet scenario, the piezoelectric component 220 is configured to: generate deformation after receiving an electrical signal, decrease a volume of the pump cavity 214, drive the liquid inlet valve film 230 to close and the liquid outlet valve film 240 to open, and provide power for the cooling medium in the liquid cooling part 100, so that the cooling medium enters the liquid cooling part 100 through the pump liquid outlet 212 and the liquid cooling inlet 112 in sequence.

In the implementation shown in FIG. 2, the liquid inlet valve film 230 is located on a side that is of the pump liquid inlet 211 and that is away from the liquid cooling outlet 111 in the thickness direction A, and the liquid outlet valve film 240 is located, in the thickness direction A, between the pump liquid outlet 212 and the liquid cooling inlet 112. In another implementation, the liquid inlet valve film 230 is located between the pump liquid inlet 211 and the pump cavity 214 in the thickness direction A, and the liquid outlet valve film 240 is located on a side that is of the liquid cooling inlet 112 and that is away from the pump liquid outlet 212 in the thickness direction A.

It should be noted that, if the piezoelectric component 220 is in a high temperature state for a long time, the piezoelectric component 220 ages, causing performance degradation. Therefore, in embodiments of this application, in addition to cooling a component of the electronic device, the liquid cooling module 10 can further optimize performance of the pump 200 included in the liquid cooling module 10.

Still refer to FIG. 2. In an implementation, the pump base 210 further includes a pump side wall 215 located between the pump bottom wall 213 and the piezoelectric component 220, and the pump side wall 215 is of an integrated sealing structure. In this implementation, the pump side wall 215 extends in the thickness direction A of the liquid cooling module 10. Because the pump side wall 215, the pump bottom wall 213, and the piezoelectric component 220 jointly enclose the pump cavity 214, the pump side wall 215 is of an integrated sealing structure in this solution, so that the cooling medium can be effectively prevented from leaking from the pump side wall 215, and sealing performance of the pump base 210 can be improved. For example, the pump side wall 215 forms the integrated sealing structure through hot pressing. The hot pressing may be a welding manner without solder paste or another third material, for example, thermo compression bonding and seal welding, thermo melt welding, ultrasonic welding, or high frequency welding.

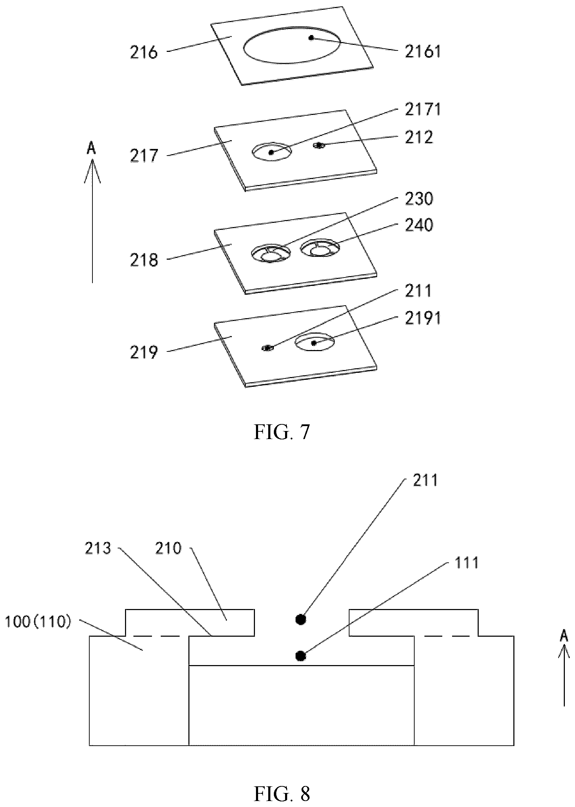

FIG. 7 is an exploded view of a stacked structure of the pump part according to the first embodiment of this application. Layers of the pump base are sealed in a welding manner without solder paste or another third material, for example, thermo compression bonding and seal welding, thermo melt welding, ultrasonic welding, or high frequency welding. In an implementation, the pump base 210 includes a pump cavity layer 216, a first runner layer 217, a valve plate layer 218, and a second runner layer 219 that are stacked in the thickness direction A, a cavity hole 2161 is provided in the pump cavity layer 216, the pump liquid outlet 212 and a first guide channel 2171 that corresponds to the pump liquid inlet 211 are disposed in the first runner layer 217, and the first runner layer 217 communicates with the cavity hole 2161 in the pump cavity layer 216; the liquid inlet valve film 230 and the liquid outlet valve film 240 that are openable and closeable are disposed in the valve plate layer 218, the pump liquid inlet 211 and a second guide channel 2191 that corresponds to the pump liquid outlet 212 are disposed in the second runner layer 219, and the second runner layer 219 communicates with the liquid cooling part 100; and the pump cavity layer 216, the first runner layer 217, the valve plate layer 218, and the second runner layer 219 form an integrated sealing structure through hot pressing.

In this implementation, the pump liquid inlet 211, the liquid inlet valve film 230, and the first guide channel 2171 are correspondingly disposed in the thickness direction A of the liquid cooling module 10, and the pump liquid outlet 212, the liquid outlet valve film 240, and the second guide channel 2191 are correspondingly disposed in the thickness direction A of the liquid cooling module 10. In this implementation shown in FIG. 7, when the liquid inlet valve film 230 is opened and the liquid outlet valve film 240 is closed, the cooling medium sequentially passes through the liquid inlet valve film 230 and the first guide channel 2171 through the pump liquid inlet 211 to enter the pump cavity 214. When the liquid outlet valve film 240 is opened and the liquid inlet valve film 230 is closed, the cooling medium sequentially passes through the liquid outlet valve film 240 and the second guide channel 2191 through the pump liquid outlet 212 to enter the liquid cooling part 100. A projection area, in the thickness direction A, of an area enclosed by a circumferential wall of the first guide channel 2171 is greater than a projection area, in the thickness direction A, of an area enclosed by a circumferential wall of the pump liquid inlet 211. This helps prevent the cooling medium from flowing back to the pump liquid inlet 211, and achieves a guide effect of the first guide channel 2171 on the cooling medium. A projection area, in the thickness direction A, of an area enclosed by a circumferential wall of the second guide channel 2191 is greater than a projection area, in the thickness direction A, of an area enclosed by a circumferential wall of the pump liquid outlet 212. This helps prevent the cooling medium from flowing back to the liquid inlet and the liquid outlet of the pump 200, and achieves a guide effect of the second guide channel 2191 on the cooling medium.

In this implementation, edges of the pump cavity layer 216, the first runner layer 217, the valve plate layer 218, and the second runner layer 219 form the pump side wall 215 (as shown in FIG. 2 and FIG. 7) through hot pressing, so that each layer is sealed, and a sealing effect of the pump base 210 is improved.

Still refer to FIG. 2. In an implementation, the liquid cooling part 100 includes a first flexible film 110, the liquid cooling outlet 111 and the liquid cooling inlet 112 are provided on the first flexible film 110, and the pump bottom wall 213, a part of the first flexible film 110 on the periphery of the liquid cooling outlet 111, and a part of the first flexible film 110 on the periphery of the liquid cooling inlet 112 are of an integrated sealing structure.

In this implementation, fastening between the liquid cooling part 100 and the pump 200 is actually fastening between the first flexible film 110 and the pump bottom wall 213. The part of the first flexible film 110 on the periphery of the liquid cooling outlet 111, the part of the first flexible film 110 on the periphery of the liquid cooling inlet 112, and the pump bottom wall 213 are of the integrated sealing structure. Because the first flexible film 110 and the pump bottom wall 213 are made of a same material or similar materials, hot-pressing molding difficulty is small, thereby facilitating forming the integrated sealing structure.

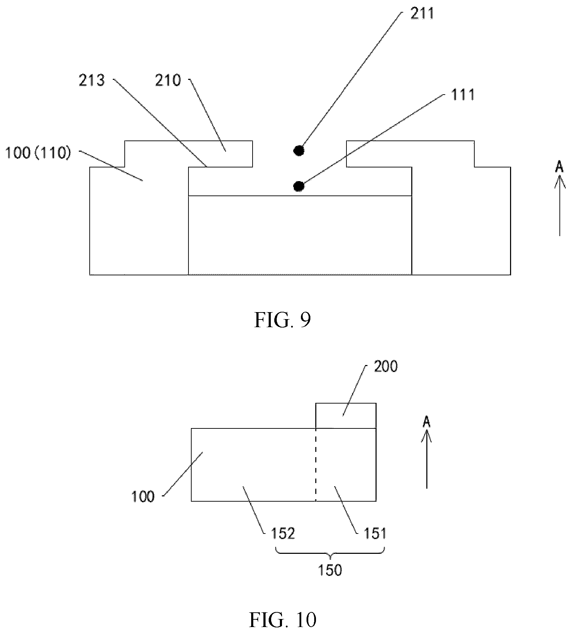

In this implementation, there are discontinuous interfaces between the first flexible film 110 and the pump bottom wall 213. FIG. 8 is a sectional view of the liquid cooling module 10 according to the first embodiment of this application. In an implementation, at least a part of the first flexible film 110 and at least a part of the pump bottom wall 213 are continuously integrated, to form an integrated sealing structure. FIG. 9 is a sectional view of the liquid cooling module 10 according to the first embodiment of this application. In another implementation, a part of the first flexible film 110 other than the liquid cooling outlet 111 and the liquid cooling inlet 112, and the pump bottom wall 213 are of an integrated sealing structure, and there is no interface between the part and the pump bottom wall 213. The sealing interface is a preferably a sealing interface, and has stronger flexibility, sealing performance, and impact resistance. However, it is difficult to achieve perfect processing in engineering. The interface is preferably a partially continuously-integrated interface, and there are micro-air gaps or non-welding areas in discontinuous contact between the interfaces.

In some implementations, to assist connection stability between the pump 200 and the liquid cooling part 100, a position at which the pump 200 is connected to the liquid cooling part 100 may be further sealed by using adhesive, thereby improving sealing performance and reliability.

Still refer to FIG. 2. In an implementation, the liquid cooling part 100 further includes a second flexible film 120 and a first rigid substrate 130 located between the first flexible film 110 and the second flexible film 120, where the first flexible film 110, the second flexible film 120, and the first rigid substrate 130 enclose an inner cavity 140 of the liquid cooling part 100, and two ends of the first rigid substrate 130, the first flexible film 110, and the second flexible film 120 are of an integrated sealing structure. In an implementation, if leakage occurs in sealing between the first rigid substrate 130, and both the first flexible film 110 and the second flexible film 120, system performance rapidly decreases and quickly becomes invalid. Two interfaces for sealing and welding among the first rigid substrate 130, the first flexible film 110 and the second flexible film 120 are made of a same material or similar materials. A welding manner without solder paste or another third material, for example, thermo compression bonding and seal welding, thermo melt welding, ultrasonic welding, or high frequency welding can be used to improve sealing performance and reliability between the first rigid substrate 130 and both the first flexible film 110 and the second flexible film 120.

In this implementation, the first flexible film 110 and the second flexible film 120 are flexible and have good bending performance, and are applicable to a case in which the liquid cooling part 100 needs to be bent. The first rigid substrate 130 is disposed between the first flexible film 110 and the second flexible film 120, and two ends of the first rigid substrate 130 are configured to support the first flexible film 110 and the second flexible film 120, thereby helping improve overall strength of the liquid cooling part 100 in the thickness direction A. The cooling medium flows in the inner cavity 140 enclosed by the first flexible film 110, the second flexible film 120, and the first rigid substrate 130. In this solution, two ends of the first rigid substrate 130, the first flexible film 110, and the second flexible film 120 are of the integrated sealing structure, so that sealing performance of the inner cavity 140 can be improved, and leakage of the cooling medium in the inner cavity 140 can be avoided.

In this implementation, there are discontinuous interfaces among the two ends of the first rigid substrate 130, the first flexible film 110, and the second flexible film 120. In an implementation, the two ends of the first rigid substrate 130, at least a part of the first flexible film 110 and at least a part of the second flexible film 120 are continuously integrated, to form an integrated sealing structure. In another implementation, the two ends of the first rigid substrate 130, the first flexible film 110, and the second flexible film 120 are all continuously integrated into an integrated sealing structure, there is no interface between the two ends of the first rigid substrate 130 and the first flexible film 110, and there is no interface between the two ends of the first rigid substrate 130 and the second flexible film 120.

In an implementation, the first rigid substrate 130 is disposed around edges of the first flexible film 110 and the second flexible film 120 (as shown in FIG. 1a). This solution helps improve strength of an edge of the liquid cooling part 100 in the thickness direction A, and the integrated sealing structure can effectively avoid leakage of the cooling medium at the edge of the liquid cooling part 100.

In an implementation, a thickness of the first flexible film 110 and a thickness of the second flexible film 120 are less than a length and a width of the liquid cooling module 10. Specifically, a ratio of each of the thickness of the first flexible film 110 and the thickness of the second flexible film 120 to the length of the liquid cooling module 10 is less than or equal to 0.2, and a ratio of each of the thickness of the first flexible film 110 and the thickness of the second flexible film 120 to the width of the liquid cooling module 10 is less than or equal to 0.2. When the liquid cooling module 10 is used in a foldable device, this solution can ensure flexibility of the first flexible film 110 and the second flexible film 120 in a bending direction, and reduce bending difficulty of the device.

In an implementation, the first flexible film 110 and the second flexible film 120 are made of a material with elongation at break greater than 10%, for example, a polymer PET, PP, PPS, PEN, or a modified film material thereof, to adapt to system pressure fluctuation and bending use. Preferably, the material of each of the first flexible film 110 and the second flexible film 120 is a material with elongation at break greater than 50%. In an implementation, anti-evaporation coating processing is performed on surfaces of the first flexible film 110 and the second flexible film 120. For example, a flexible inorganic oxide film is coated on a surface of a polymer film to isolate moisture. A specific coating manner may be physical vapor deposition (PVD), chemical vapor deposition (CVD), atomic layer deposition (ALD), and other process means.

Still refer to FIG. 2. In an implementation, the liquid cooling part 100 further includes a second rigid substrate 150, the second rigid substrate 150 separates the inner cavity 140 of the liquid cooling part 100 into a liquid inlet runner 142 and a liquid outlet runner 141, the liquid cooling inlet 112 communicates with the liquid inlet runner 142, the liquid cooling outlet 111 communicates with the liquid outlet runner 141, and two ends of the second rigid substrate 150, the first flexible film 110, and the second flexible film 120 are of an integrated sealing structure. If leakage occurs in separating and sealing between the second rigid substrate 150 and both the first flexible film 110 and the second flexible film 120, performance of the liquid cooling system greatly decreases and gradually becomes invalid. In this implementation, two ends of the second rigid substrate 150, the first flexible film 110, and the second flexible film 120 are of the integrated sealing structure, so that sealing performance and reliability are improved.

In this implementation, the second rigid substrate 150 is configured to separate a runner of the inner cavity 140 into the liquid inlet runner 142 and the liquid outlet runner 141, and each of the liquid inlet runner 142 and the liquid outlet runner 141 is enclosed by the second rigid substrate 150, the first rigid substrate 130, the first flexible film 110, and the second flexible film 120. The liquid inlet runner 142 is kept in a communication state with the liquid cooling inlet 112, and the liquid outlet runner 141 is kept in a communication state with the liquid cooling outlet 111. The liquid inlet runner 142 and the liquid outlet runner 141 are separated through the second rigid substrate 150. This helps avoid reducing cooling efficiency due to mixed flow of the cooling medium in the liquid inlet runner 142 and the liquid outlet runner 141. The two ends of the second rigid substrate 150 are integrally sealed with the first flexible film 110 and the second flexible film 120 through hot pressing. This helps improve an isolation effect between the liquid inlet runner 142 and the liquid outlet runner 141, and can further improve structural strength of the liquid cooling part 100.

It may be understood that the liquid inlet runner 142 and the liquid outlet runner 141 are not two parts that are completely isolated, and the second rigid substrate 150 merely separates the liquid inlet runner 142 and the liquid outlet runner 141 that are adjacent to the pump 200. To enable the cooling medium to circulate in the liquid cooling part 100, the liquid inlet runner 142 and the liquid outlet runner 141 communicate with each other in an area away from the pump 200. For example, in the liquid cooling module 10 shown in FIG. 1a, the liquid inlet runner 142 and the liquid outlet runner 141 communicate with each other in a narrow end area.

In this implementation, there are discontinuous interfaces among the two ends of the second rigid substrate 150, the first flexible film 110, and the second flexible film 120. In an implementation, the two ends of the second rigid substrate 150, at least a part of the first flexible film 110 and at least a part of the second flexible film 120 are continuously integrated, to form an integrated sealing structure. In another implementation, the two ends of the second rigid substrate 150, the first flexible film 110, and the second flexible film 120 are all continuously integrated into an integrated sealing structure, there is no interface between the two ends of the second rigid substrate 150 and the first flexible film 110, and there is no interface between the two ends of the second rigid substrate 150 and the second flexible film 120.

Refer to FIG. 2 and FIG. 10. FIG. 10 is a side view of the pump 200 and the second rigid substrate 150 according to the first embodiment of this application. In an implementation, the second rigid substrate 150 includes a first sub-rigid substrate 151 located below the pump 200 and a second sub-rigid substrate 152 located outside the pump 200 (as shown in FIG. 10). An orthographic projection, on the second flexible film 120, of the first sub-rigid substrate 151 does not overlap an orthographic projection, on the second flexible film 120, of an area enclosed by an edge of the liquid cooling inlet 112 and an edge of the liquid cooling outlet 111 (as shown in FIG. 2). The lower part of the pump 200 refers to a side that is of the pump 200 and that is close to the liquid cooling part 100 in the thickness direction A. In an implementation, an orthographic projection, on the second flexible film 120, of the first sub-rigid substrate 151 does not overlap an orthographic projection, on the second flexible film 120, of an area enclosed by an edge of the pump liquid inlet 211 and an edge of the pump liquid outlet 212. In an implementation, for ease of processing or for better separation of runners on the two sides of the pump 200 through the first sub-rigid substrate 151, the first sub-rigid substrate 151 may extend slightly outside of the pump 200. As shown in FIG. 1a, a length of the first sub-rigid substrate 151 in a left-right direction is greater than a length of the pump 200 in the left-right direction in FIG. 1a.

In an implementation, the first sub-rigid substrate 151 and the first rigid substrate 130 are made of a same material (as shown in FIG. 1a and FIG. 1b). The first sub-rigid substrate 151 is positioned below the pump 200. In this case, a cooling liquid pumped out by the pump 200 during working has impact pressure on the first sub-rigid substrate 151 when entering or exiting the liquid cooling inlet 112 and the liquid cooling outlet 111. This leads the system performance to rapidly decrease and become invalid. The first sub-rigid substrate 151 and the first rigid substrate 130 are made of a same material, so that a sealing effect and structural strength between the first sub-rigid substrate 151 and both the first flexible film 110 and the second flexible film 120 are the same as a sealing effect and structural strength between the first rigid substrate 130 and both the first flexible film 110 and the second flexible film 120, thereby effectively improving the sealing effect and structural strength between the first sub-rigid substrate 151 and both the first flexible film 110 and the second flexible film 120, and avoiding impact on the sealing effect due to impact of a liquid near the pump 200 on the first sub-rigid substrate 151.

In an implementation, the first sub-rigid substrate 151 and the first rigid substrate 130 are of an integrated structure, thereby improving sealing performance and reliability between the first sub-rigid substrate 151 and the first rigid substrate 130, as shown in FIG. 1a. In an implementation, the first sub-rigid substrate 151 and the second sub-rigid substrate 152 are of an integrated structure. This improves sealing performance and reliability between the first sub-rigid substrate 151 and the second sub-rigid substrate 152.

In an implementation, the first sub-rigid substrate 151 and the first rigid substrate 130 are simultaneously welded with the first flexible film 110 or the second flexible film 120 through hot pressing, to improve a sealing effect and structural strength between the first sub-rigid substrate 151 and the first flexible film 110 or the second flexible film 120.

In an implementation, the second rigid substrate 150 is integrally bar-shaped. In this solution, processing costs can be reduced, and a regular shape of the second rigid substrate 150 helps reduce flow resistance generated by the second rigid substrate 150 on the cooling medium.

In an implementation, an integrated sealing structure is provided between the first flexible film 110 that is disposed corresponding to the second rigid substrate 150 in the thickness direction A and the pump bottom wall 213. This solution can further ensure that the cooling medium in the liquid inlet runner 142 and the liquid outlet runner 141 does not have a short-circuit and mixed flow.

Still refer to FIG. 2. In an implementation, the liquid cooling part 100 further includes a third rigid substrate 160, the third rigid substrate 160 is distributed in the liquid inlet runner 142 and the liquid outlet runner 141, and two ends of the third rigid substrate 160, the first flexible film 110, and the second flexible film 120 are of an integrated sealing structure. If leakage occurs in separating and sealing between the third rigid substrate 160 and both the first flexible film 110 and the second flexible film 120, performance of the liquid cooling system slightly decreases, but the entire liquid cooling system does not become invalid.

In this implementation, a plurality of third rigid substrates 160 separate the liquid inlet runner 142 into a plurality of liquid inlet sub-runners that communicate with each other, and separate the liquid outlet runner 141 into a plurality of liquid outlet sub-runners that communicate with each other. The third rigid substrates 160 respectively achieve a flow guide function in the liquid inlet runner 142 and the liquid outlet runner 141, thereby reducing flow resistance and avoiding an eddy flow loss, and helping enhance a heat exchange effect of the cooling medium. The third rigid substrate 160 may be integrally bar-shaped or cylindrical. The third rigid substrate 160 in a bar shape helps guide flow of the cooling medium, and the third rigid substrate 160 in a cylindrical shape helps strengthen mixing of the cooling medium.

Still refer to FIG. 1a. In an implementation, because the third rigid substrate 160 has a function of simultaneously guiding and mixing flow, the third rigid substrate 160 may be disposed in an area in which a width of the liquid inlet runner 142 or the liquid outlet runner 141 is suddenly changed, an area in which a flow direction of the cooling medium is suddenly changed, and an area adjacent to the liquid cooling inlet 112.

In this implementation, there are discontinuous interfaces among the two ends of the third rigid substrate 160, the first flexible film 110, and the second flexible film 120. In an implementation, the two ends of the third rigid substrate 160, at least a part of the first flexible film 110 and at least a part of the second flexible film 120 are continuously integrated, to form an integrated sealing structure. In another implementation, the two ends of the third rigid substrate 160, the first flexible film 110, and the second flexible film 120 are all continuously integrated into an integrated sealing structure, there is no interface between the two ends of the third rigid substrate 160 and the first flexible film 110, and there is no interface between the two ends of the second rigid substrate 150 and the second flexible film 120.

In an implementation, a thickness of the first rigid substrate 130, a thickness of the second rigid substrate 150, and a thickness of the third rigid substrate 160 are all less than a width of the liquid cooling module 10. Specifically, a ratio range of each of the thickness of the first rigid substrate 130, the thickness of the second rigid substrate 150, and the thickness of the third rigid substrate 160 to the width of the liquid cooling module 10 is greater than or equal to 0.1 and less than or equal to 0.2. The thickness of the first rigid substrate 130, the thickness of the second rigid substrate 150, and the thickness of the third rigid substrate 160 are all less than a length of the liquid cooling module 10. Specifically, a ratio range of each of the thickness of the first rigid substrate 130, the thickness of the second rigid substrate 150, and the thickness of the third rigid substrate 160 to the length of the liquid cooling module 10 is greater than or equal to 10 to 5 and less than or equal to 0.2. This solution helps ensure high strength of the liquid cooling module 10 in the thickness direction and flexibility of the liquid cooling module 10 in a length direction and a width direction.

In an implementation, a sum of cross-sectional areas of the first rigid substrate 130, the second rigid substrate 150, and the third rigid substrate 160 is less than an area of the first flexible film 110 or the second flexible film 120. The area of the first flexible film 110 is an area of a surface facing the rigid substrate, and the area of the second flexible film 120 is an area of a surface facing the rigid substrate.

In an implementation, a value of a width of the first rigid substrate 130 is greater than or equal to 1 mm and less than or equal to 10 mm. A width direction of the first rigid substrate 130 intersects with the thickness direction A and an extension direction of the first rigid substrate 130.

In an implementation, a value of a width of the second rigid substrate 150 is greater than or equal to 1 mm and less than or equal to 10 mm. A width direction of the second rigid substrate 150 intersects with the thickness direction A and an extension direction of the second rigid substrate 150.

In an implementation, when the third rigid substrate 160 is long-bar-shaped, a value of a width of the third rigid substrate 160 is greater than or equal to 1 mm and less than or equal to 10 mm. A width direction of the third rigid substrate 160 intersects with the thickness direction A and an extension direction of the third rigid substrate 160.

In an implementation, a value of the thickness of the first flexible film 110 is greater than or equal to 5 µm and less than or equal to 500 µm. For example, the value of the thickness of the first flexible film 110 is 40 µm.

In an implementation, a value of the thickness of the second flexible film 120 is greater than or equal to 5 µm and less than or equal to 500 µm. For example, the value of the thickness of the second flexible film 120 is 40 µm.

In an implementation, a value of each of the thickness of the first rigid substrate 130, the thickness of the second rigid substrate 150, and the thickness of the third rigid substrate 160 is greater than or equal to 0.1 mm and less than or equal to 1 mm. For example, the value of each of the thickness of the first rigid substrate 130, the thickness of the second rigid substrate 150, and the thickness of the third rigid substrate 160 is 0.12 mm.

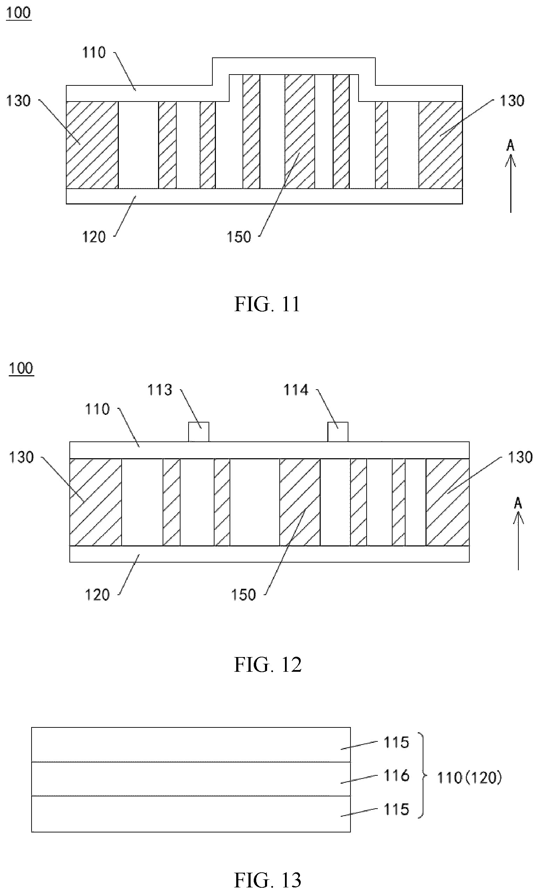

FIG. 11 is a sectional view of the liquid cooling part 100 according to the first embodiment of this application. In an implementation, the thickness of the first rigid substrate 130, the thickness of the second rigid substrate 150, and the thickness of the third rigid substrate 160 are unequal. The thickness is a size in the thickness direction A. In this implementation, the three rigid substrates are in an unequal-thickness design. When the liquid cooling module 10 is used in a foldable device, space in the foldable device is fully utilized, and other components in the device are avoided, so that a layout is optimized.

FIG. 12 is a sectional view of the liquid cooling part 100 according to the first embodiment of this application. In an implementation, the first flexible film 110 or the second flexible film 120 may be further provided with a liquid injection opening 113, a gas extraction opening 114, and the like. The liquid injection opening 113, the gas extraction opening 114, and at least one of the three rigid substrates, and the first flexible film 110 or the second flexible film 120 are of an integrated sealing structure. In this implementation, the liquid injection opening 113 is configured to inject the cooling medium into the inner cavity 140 before cooling, and the gas extraction opening 114 is configured to extract gas from the inner cavity 140, to avoid negative impact on a heat dissipation effect. The liquid injection opening 113 and the gas extraction opening 114 are integrally sealed and connected to at least one of the first rigid substrate 130, the second rigid substrate 150, and the third rigid substrate 160, and the first flexible film 110 or the second flexible film 120. This helps avoid leakage of the cooling medium in the liquid injection opening 113 and the gas extraction opening 114. To achieve an ultra-thin effect, the liquid injection opening 113, the gas extraction opening 114, and the liquid cooling part 100 are on a same plane, that is, between the first flexible film 110 and the second flexible film 120. In engineering, the liquid injection opening 113, the gas extraction opening 114, and the liquid cooling part 100 can be configured to assist in adhesive dispensing, to enhance structural positioning and strength, but not to seal a welding surface.

In an implementation, a difference between a glass transition temperature of a material of the pump bottom wall 213 and a glass transition temperature of a material of the first flexible film 110 is less than or equal to 20°C. If the materials are the same, the difference is zero. The glass transition temperature refers to a temperature corresponding to transition from a glass state to a high-elastic state. A higher glass transition temperature indicates better heat resistance of a material. In this implementation, the difference between the glass transition temperature of the material of the pump bottom wall 213 and the glass transition temperature of the material of the first flexible film 110 is set to a small value, so that the pump bottom wall 213 and the first flexible film 110 are sealed into an integrated structure through thermo compression bonding, thereby improving a sealing effect between the pump bottom wall 213 and the first flexible film 110.

In an implementation, a difference between a glass transition temperature of a material of the first rigid substrate 130 and a glass transition temperature of a material of the first flexible film 110 or the second flexible film 120 is less than or equal to 20°C. The difference between the glass transition temperature of the material of the first rigid substrate 130 and the glass transition temperature of the material of the first flexible film 110 or the second flexible film 120 is set to a small value, so that the first rigid substrate 130 and the first flexible film 110 or the second flexible film 120 are sealed into an integrated structure through thermo compression bonding, thereby improving a sealing effect between the first rigid substrate 130 and the first flexible film 110 or the second flexible film 120.

In an implementation, a difference between a glass transition temperature of a material of the second rigid substrate 150 and a glass transition temperature of a material of the first flexible film 110 or the second flexible film 120 is less than or equal to 20°C. The difference between the glass transition temperature of the material of the second rigid substrate 150 and the glass transition temperature of the material of the first flexible film 110 or the second flexible film 120 is set to a small value, so that the second rigid substrate 150 and the first flexible film 110 or the second flexible film 120 are sealed into an integrated structure through thermo compression bonding, thereby improving a sealing effect between the second rigid substrate 150 and the first flexible film 110 or the second flexible film 120.

In an implementation, a difference between a glass transition temperature of a material of the third rigid substrate 160 and a glass transition temperature of a material of the first flexible film 110 or the second flexible film 120 is less than or equal to 20°C. The difference between the glass transition temperature of the material of the third rigid substrate 160 and the glass transition temperature of the material of the first flexible film 110 or the second flexible film 120 is set to a small value, so that the third rigid substrate 160 and the first flexible film 110 or the second flexible film 120 are sealed into an integrated structure through thermo compression bonding, thereby improving a sealing effect between the third rigid substrate 160 and the first flexible film 110 or the second flexible film 120.

In an implementation, a difference between a glass transition temperature of a material of the pump base 210 and a glass transition temperature of a material of the liquid cooling part 100 is less than or equal to 20°C. If the materials are the same, the difference is zero.

In an implementation, a value of the glass transition temperature of the material of the pump bottom wall 213 is greater than or equal to 69°C and less than or equal to 243°C.

In an implementation, a value of the glass transition temperature of the material of the first flexible film 110 is greater than or equal to 69°C and less than or equal to 243°C.

In an implementation, a value of the glass transition temperature of the material of the second flexible film 120 is greater than or equal to 69°C and less than or equal to 243°C.

In an implementation, a value of the glass transition temperature of the material of the first rigid substrate 130 is greater than or equal to 69°C and less than or equal to 243°C.

In an implementation, a value of the glass transition temperature of the material of the second rigid substrate 150 is greater than or equal to 69°C and less than or equal to 243°C.

In an implementation, a value of the glass transition temperature of the material of the third rigid substrate 160 is greater than or equal to 69°C and less than or equal to 243°C.

In this implementation, it should be noted that, although value ranges of the glass transition temperatures of the materials of the pump bottom wall 213, the first flexible film 110, the second flexible film 120, the first rigid substrate 130, the second rigid substrate 150, and the third rigid substrate 160 overlap, in an actual case, the glass transition temperatures of the materials of the pump bottom wall 213, the first flexible film 110, the second flexible film 120, the first rigid substrate 130, the second rigid substrate 150, and the third rigid substrate 160 do not need to be completely equal, provided that a difference is less than or equal to 20°C.

In an implementation, a difference between a melting temperature of the material of the pump bottom wall 213 and a melting temperature of the material of the first flexible film 110 is less than or equal to 20°C. In this implementation, the difference between the melting temperature of the material of the pump bottom wall 213 and the melting temperature of the material of the first flexible film 110 is set to a small value, so that the pump bottom wall 213 and the first flexible film 110 are sealed into an integrated structure through thermo compression bonding, thereby improving a sealing effect between the pump bottom wall 213 and the first flexible film 110.

In an implementation, a difference between a melting temperature of a material of the first rigid substrate 130 and a melting temperature of a material of the first flexible film 110 or the second flexible film 120 is less than or equal to 20°C. The difference between the melting temperature of the material of the first rigid substrate 130 and the melting temperature of the material of the first flexible film 110 or the second flexible film 120 is set to a small value, so that the first rigid substrate 130 and the first flexible film 110 or the second flexible film 120 are sealed into an integrated structure through thermo compression bonding, thereby improving a sealing effect between the first rigid substrate 130 and the first flexible film 110 or the second flexible film 120.

In an implementation, a difference between a melting temperature of a material of the second rigid substrate 150 and a melting temperature of a material of the first flexible film 110 or the second flexible film 120 is less than or equal to 20°C. The difference between the melting temperature of the material of the second rigid substrate 150 and the melting temperature of the material of the first flexible film 110 or the second flexible film 120 is set to a small value, so that the second rigid substrate 150 and the first flexible film 110 or the second flexible film 120 are sealed into an integrated structure through thermo compression bonding, thereby improving a sealing effect between the second rigid substrate 150 and the first flexible film 110 or the second flexible film 120.

In an implementation, a difference between a melting temperature of a material of the third rigid substrate 160 and a melting temperature of a material of the first flexible film 110 or the second flexible film 120 is less than or equal to 20°C. The difference between the melting temperature of the material of the third rigid substrate 160 and the melting temperature of the material of the first flexible film 110 or the second flexible film 120 is set to a small value, so that the third rigid substrate 160 and the first flexible film 110 or the second flexible film 120 are sealed into an integrated structure through thermo compression bonding, thereby improving a sealing effect between the third rigid substrate 160 and the first flexible film 110 or the second flexible film 120.

In an implementation, a value of the melting temperature of the material of the pump bottom wall 213 is greater than or equal to 195°C and less than or equal to 343°C.

In an implementation, a value of the melting temperature of the material of the first flexible film 110 is greater than or equal to 195°C and less than or equal to 343°C.

In an implementation, a value of the melting temperature of the material of the second flexible film 120 is greater than or equal to 195°C and less than or equal to 343°C.

In an implementation, a value of the melting temperature of the material of the first rigid substrate 130 is greater than or equal to 195°C and less than or equal to 343°C.

In an implementation, a value of the melting temperature of the material of the second rigid substrate 150 is greater than or equal to 195°C and less than or equal to 343°C.

In an implementation, a value of the melting temperature of the material of the third rigid substrate 160 is greater than or equal to 195°C and less than or equal to 343°C.

In an implementation, a difference between a melting temperature of the material of the pump base 210 and a melting temperature of the material of the first flexible film 110 is less than or equal to 20°C.

In this implementation, it should be noted that, although value ranges of the melting temperatures of the materials of the pump bottom wall 213, the first flexible film 110, the second flexible film 120, the first rigid substrate 130, the second rigid substrate 150, and the third rigid substrate 160 overlap, in an actual case, the melting temperatures of the materials of the pump bottom wall 213, the first flexible film 110, the second flexible film 120, the first rigid substrate 130, the second rigid substrate 150, and the third rigid substrate 160 do not need to be completely equal, provided that a difference is less than or equal to 20°C.

In an implementation, the material of the pump base 210 and the pump bottom wall 213 is a flexible temperature-resistant polymer material with elongation at break greater than 10%. In an implementation, the material of the pump base 210 and the pump bottom wall 213 is a flexible temperature-resistant polymer material with elongation at break greater than 50%.

In an implementation, the materials of the pump base 210 and the pump bottom wall 213 are independently selected from at least one of a polyethylene terephthalate copolymer, polyethylene naphthalate, polyethylene 2,5-furandicarboxylate, polyimide, polyetheretherketone, and biaxially oriented polypropylene.

In an implementation, materials of the first flexible film 110, the second flexible film 120, the first rigid substrate 130, the second rigid substrate 150, and the third rigid substrate 160 are independently selected from a flexible temperature-resistant polymer material with elongation at break greater than 10%. In an implementation, materials of the first flexible film 110, the second flexible film 120, the first rigid substrate 130, the second rigid substrate 150, and the third rigid substrate 160 are independently selected from a flexible temperature-resistant polymer material with elongation at break greater than 50%.

In an implementation, the material of the first flexible film 110 is selected from at least one of a polyethylene terephthalate copolymer, polyethylene naphthalate, polyethylene 2,5-furandicarboxylate, polyimide, polyetheretherketone, and biaxially oriented polypropylene.

In an implementation, the material of the first rigid substrate 130 is selected from at least one of a polyethylene terephthalate copolymer, polyethylene naphthalate, polyethylene 2,5-furandicarboxylate, polyimide, polyetheretherketone, and biaxially oriented polypropylene.

In an implementation, the material of the second flexible film 120 is selected from at least one of a polyethylene terephthalate copolymer, polyethylene naphthalate, polyethylene 2,5-furandicarboxylate, polyimide, polyetheretherketone, and biaxially oriented polypropylene.

In an implementation, the material of the second rigid substrate 150 is selected from at least one of a polyethylene terephthalate copolymer, polyethylene naphthalate, polyethylene 2,5-furandicarboxylate, polyimide, polyetheretherketone, and biaxially oriented polypropylene.

In an implementation, the material of the third rigid substrate 160 is selected from at least one of a polyethylene terephthalate copolymer, polyethylene naphthalate, polyethylene 2,5-furandicarboxylate, polyimide, polyetheretherketone, and biaxially oriented polypropylene.

The polyethylene terephthalate copolymer, polyethylene naphthalate, polyethylene 2,5-furandicarboxylate, polyimide, polyetheretherketone, and biaxially oriented polypropylene each include rigid chain segments, and have a high glass transition temperature.

In this implementation, materials selected by the pump bottom wall 213 and the first flexible film 110 help form an integrated sealing structure between the pump bottom wall 213 and the first flexible film 110 through hot pressing. Materials selected by the first rigid substrate 130 and the first flexible film 110 or the second flexible film 120 help form an integrated sealing structure between the first rigid substrate 130 and the first flexible film 110 or the second flexible film 120 through hot pressing. Material selected by the second rigid substrate 150 and the first flexible film 110 or the second flexible film 120 help form an integrated sealing structure between the second rigid substrate 150 and the first flexible film 110 or the second flexible film 120 through hot pressing. Material selected by the third rigid substrate 160 and the first flexible film 110 or the second flexible film 120 help form an integrated sealing structure between the third rigid substrate 160 and the first flexible film 110 or the second flexible film 120 through hot pressing. The hot pressing may be a welding manner without solder paste or another third material, for example, thermo compression bonding and seal welding, thermo melt welding, ultrasonic welding, or high frequency welding of a polymer film material. The first flexible film 110 and the second flexible film 120 are made of the foregoing materials, thereby helping improve elongation rate at break, release stress of an electronic device during bending, and absorb volume changes caused by pressure fluctuation, thermal expansion and cold contraction, and the like of a liquid cooling system.

For example, the pump bottom wall 213 and the first flexible film 110 are made of a same material. The first rigid substrate 130 and the first flexible film 110 or the second flexible film 120 are made of a same material. The second rigid substrate 150 and the first flexible film 110 or the second flexible film 120 are made of a same material. The third rigid substrate 160 and the first flexible film 110 or the second flexible film 120 are made of a same material. For example, a material of the pump base 210 is the same as a material of the liquid cooling part 100.

In a conventional liquid cooling module, as shown in Table 1, a runner is formed by using a film material like polymer PET, PP or PPS. Small molecules such as water penetrate a film made of a polymer material, and an amount of penetration increases with evaporation and a temperature index.

**Table 1: Variation of evaporation amount of a polymer film with time-temperature (a working medium is water, and a molecular weight is 18)**

| Temperature | Time | | | | |
|---|---|---|---|---|---|
| | 1 day | 5 days | 11 days | 15 days | 25 days |
| 65°C | 0.2% | 0.9% | 1.9% | 2.5% | 4.4% |
| 25°C | 0.0% | 0.0% | 0.0% | 0.0% | 0.1% |

In this implementation, the materials of the first flexible film 110 and the second flexible film 120 are selected from at least one of a polyethylene terephthalate copolymer, polyethylene naphthalate, polyethylene 2,5-furandicarboxylate, polyimide, polyetheretherketone, and biaxially oriented polypropylene. Because the foregoing material has a low moisture transmission rate, therefore, the foregoing material used for the first flexible film 110 and the second flexible film 120 further helps alleviate a problem of evaporation of the cooling medium on the first flexible film 110 and the second flexible film 120. If the first flexible film 110 and the second flexible film 120 are made of a conventional PET material, because the PET material has an ester group with high polarity and has a strong absorption effect on water molecules, when the cooling medium flows in the inner cavity 140 of the liquid cooling part 100, the cooling medium may penetrate the first flexible film 110 and the second flexible film 120 due to evaporation. This leads to decrease of a utilization rate of the cooling medium. In a process in which the cooling medium evaporates outward, small-molecule gas in air is dissolved into the cooling medium by replacing through the first flexible film 110 and the second flexible film 120. When dissolved to saturation, the air may exist in a form of bubble in a cooling medium cycle. In addition to interfering with a liquid cooling cycle and affecting heat dissipation efficiency, these bubbles may also be sucked into the pump 200. This not only affects efficiency of the pump 200, but also causes noise when the pump 200 rotates, and even causes damage to the pump 200. Therefore, in this solution, the first flexible film 110 and the second flexible film 120 are made of the foregoing materials, helping avoid a series of hazards caused by evaporation of the cooling medium.

In an implementation, an evaporation dispersion order of the first flexible film 110 and the second flexible film 120 is reduced by more than one order of magnitude. In this case, evaporation requirements of different working media such as water and fluoride liquid at different application temperatures are met.

It should be noted that, to form the integrated sealing structures between the two flexible films and the three rigid substrates through hot pressing, the first flexible film 110, the second flexible film 120, the first rigid substrate 130, the second rigid substrate 150, and the third rigid substrate 160 may be made of a same material, and the flexible film and the rigid substrate have different requirements for flexibility. In this case, thicknesses of the flexible film and the rigid substrate may be adjusted to implement different levels of flexibility.

In an implementation, a glass transition temperature of the polyethylene terephthalate copolymer is greater than or equal to 69°C and less than or equal to 77°C, and a melting temperature of the polyethylene terephthalate copolymer is greater than or equal to 250°C and less than or equal to 255°C. A glass transition temperature of polyethylene naphthalate is 122.4°C and a melting temperature of polyethylene naphthalate is 211.6°C. A glass transition temperature of polyethylene 2,5-furandicarboxylate is 87.2°C, and a melting temperature of polyethylene 2,5-furandicarboxylate is greater than or equal to 195°C and less than or equal to 265°C. A glass transition temperature of polyimide is 243°C and a melting temperature of polyimide is 334°C. A glass transition temperature of polyetheretherketone is greater than or equal to 143°C and less than or equal to 150°C, and a melting temperature of polyetheretherketone is 343°C. It should be noted that the glass transition temperature and the melting temperature mentioned above are both experimental values, and are affected by a plurality of factors such as an experimental condition, an instrument device, and an experimental operation. When the foregoing factors change, the glass transition temperature and the melting temperature of the foregoing material may also change accordingly. A person skilled in the art should understand that such a deviation is difficult to avoid. In this embodiment of this application, it only needs to be ensured that a difference between glass transition temperatures or melting temperatures between two components that need to form an integrated sealing structure is less than or equal to 20°C. Specific values of the glass transition temperatures and the melting temperatures of the pump bottom wall 213, the pump base 210, the first flexible film 110, the second flexible film 120, the first rigid substrate 130, the second rigid substrate 150, and the third rigid substrate 160 are not absolutely limited in this application.

In an implementation, a monomer of the polyethylene terephthalate copolymer includes terephthalic acid, ethylene glycol, and a hard segment molecular structure, and a value of a mass percentage of the hard segment molecular structure to the polyethylene terephthalate copolymer is greater than or equal to 20% and less than or equal to 80%.

The polyethylene terephthalate copolymer is a copolymer formed through copolymerization of a monomer of PET (polyethylene terephthalate, polyethylene terephthalate) and another monomer block, where the PET is formed by polymerizing terephthalic acid and ethylene glycol. Because there is a -CH2-CH2- molecular chain segment in a PET structure, a glass transition temperature of the PET is low, and glass transition is likely to occur in an application environment with a medium-high temperature, and there is a dimension stability risk. In this solution, a hard segment molecular structure is introduced into the PET structure, so that the glass transition temperature of the polyethylene terephthalate copolymer can be increased. When the polyethylene terephthalate copolymer is applied to the liquid cooling module 10, the liquid cooling module 10 can be applied to an application scenario with a medium-high temperature.

In this implementation, the hard segment molecular structure is set to the foregoing ratio, so that structural strength of the polyethylene terephthalate copolymer can be improved. When the polyethylene terephthalate copolymer is applied to the liquid cooling module 10, impact resistance and drop resistance of the liquid cooling module 10 can be improved, and another component inside the electronic device can be effectively protected.

In an implementation, the hard segment molecular structure is selected from at least one of 2,5-furandicarboxylic acid, dimethyl carbonate, and 2,6-naphthalenedicarboxylic acid. In this implementation, 2,5-furandicarboxylic acid, dimethyl carbonate, and 2,6-naphthalenedicarboxylic acid are respectively monomers of polyethylene 2,5-furandicarboxylate, polycarbonate, and polyethylene naphthalate. The foregoing material is used as a hard segment molecular structure, so that structural strength of the polyethylene terephthalate copolymer can be improved. When another hard segment molecular structure other than the dimethyl carbonate is used, an evaporation problem of the first flexible film 110 and the second flexible film 120 can be further alleviated, and water permeability and air permeability can be reduced.

In the foregoing implementation, molecular structures of some polymers are shown in Table 2.

**Table 2 Structures of some polymer materials**

| Polymer name | Structural formula |
|---|---|
| Polyethylene terephthalate copolymer | 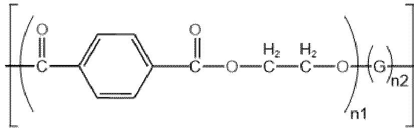 |
| Polyethylene naphthalate | 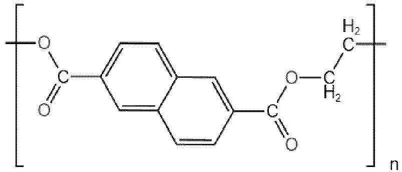 |
| Polyethylene 2,5-furandicarboxylate | 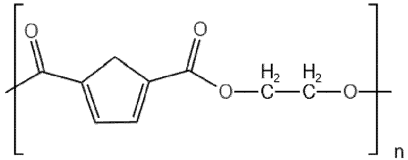 |

In the foregoing implementation, some hard segment molecular structures G are shown in Table 3.

**Table 3 Hard segment molecular structures**

| Names of the hard segment molecular structures | Structural formula |
|---|---|
| 2,5-furandicarboxylic acid | 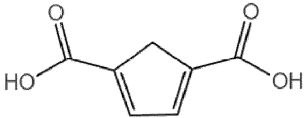 |
| Dimethyl carbonate | 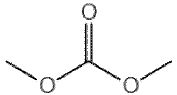 |
| 2,6-naphthalenedicarboxylic acid | 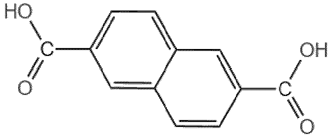 |

FIG. 13 is a sectional view of the first flexible film 110 according to the first embodiment of this application. In an implementation, at least one of the first flexible film 110 and the second flexible film 120 includes two sub-flexible film layers 115 and an anti-evaporation layer 116 located between the two sub-flexible film layers 115, and the anti-evaporation layer 116 includes at least one of a polyimide layer, a polyvinylidene chloride layer, or a metal film layer.

In this implementation, a material of the sub-flexible film layer 115 may be either of a material of the first flexible film 110 or a material of the second flexible film 120. In an implementation, a material of the sub-flexible film layer 115 may be the foregoing polyethylene terephthalate copolymer, PET copolymer for short.

In this implementation, a multi-layer film process is used for at least one of the first flexible film 110 and the second flexible film 120, that is, the first flexible film 110 and the second flexible film 120 are disposed as a sandwich structure of "PET copolymer-X-PET copolymer", where the X layer is the anti-evaporation layer 116. Polyimide, polyvinylidene chloride, and a metal film are materials with a low moisture transmission rate. The anti-evaporation layer 116 is made of the foregoing material, so that moisture evaporation in the first flexible film 110 and the second flexible film 120 can be reduced. In an implementation, a multi-layer co-extrusion technology or a multi-layer film compression technology is used to implement a multi-layer film structure in the first flexible film 110 and the second flexible film 120.

In an implementation, the metal thin film layer may be a copper film, a nickel film, an aluminum film, or a metal-plastic composite film material, and has a thickness less than or equal to 10 micrometers. In this implementation, when the liquid cooling module 10 is used in a foldable device, this solution helps ensure that the first flexible film 110 and the second flexible film 120 meet a requirement of 100,000 to 400,000 bending tests at different bending angles.

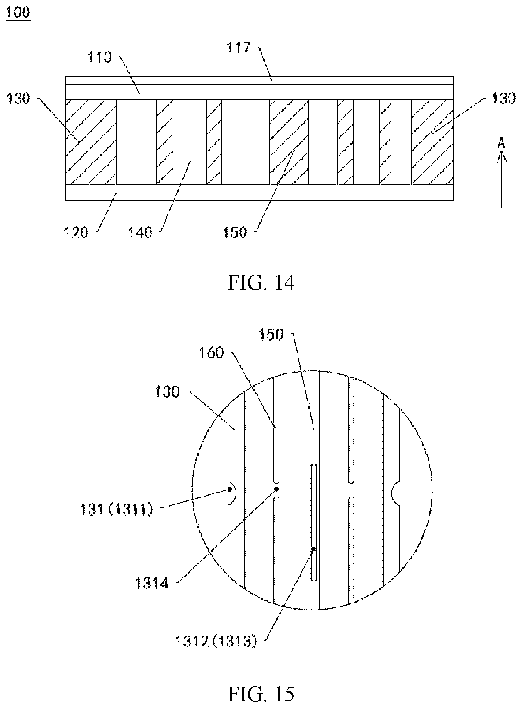

FIG. 14 is a sectional view of the liquid cooling part 100 according to the first embodiment of this application. In an implementation, an inorganic oxide film 117 is provided on a surface that is of at least one of the first flexible film 110 and the second flexible film 120 and that is away from the inner cavity 140.

In this implementation, although surfaces that are of the first flexible film 110 and the second flexible film 120 and that are away from the inner cavity 140 are not in direct contact with the cooling medium, both are interfaces through which the cooling medium should pass when evaporated to the outside. The inorganic oxide film 117 is disposed, to help isolate moisture and alleviate an evaporation problem of the cooling medium. For example, the inorganic oxide film 117 may be coated through any one of physical vapor deposition, chemical vapor deposition, and atomic layer deposition.

Refer to FIG. 1a and FIG. 15 together. FIG. 15 is a partially enlarged view of the liquid cooling module 10 shown in FIG. 1a. **In** an implementation, the liquid cooling part 100 includes a liquid cooling film bending area 170 (as shown in FIG. 1a), and the liquid cooling part 100 is folded through the liquid cooling film bending area 170; and at least one of the first rigid substrate 130, the second rigid substrate 150, and the third rigid substrate 160 is provided with a flexibility-enhancement structure 131 (as shown in FIG. 1a and FIG. 15). The flexibility-enhancement structure 131 is located in the liquid cooling film bending area 170, and the flexibility-enhancement structure 131 is configured to enhance flexibility of the liquid cooling film bending area 170.

In this implementation, the first rigid substrate 130, the second rigid substrate 150, and the third rigid substrate 160 can enhance strength of the liquid cooling part 100 in the thickness direction A because of rigidity. When the liquid cooling part 100 is used in the foldable device, and a bendable part of the liquid cooling part 100 needs to have specific flexibility, in this solution, the flexibility-enhancement structure 131 is disposed in the liquid cooling film bending area 170 of the liquid cooling part 100. This can reduce resistance to the bendable part of the liquid cooling part 100 during bending, and can meet a folding requirement of the electronic device.

In an implementation, the flexibility-enhancement structure 131 may be at least one of a groove, a penetration hole, a through hole, and an opening.

In an implementation, the liquid cooling part 100 further includes a first liquid cooling film static area 180 and a second liquid cooling film static area 190 (as shown in FIG. 1a) that are located on two sides of the liquid cooling film bending area 170. When bending in the liquid cooling film bending area 170 is performed, the first liquid cooling film static area 180 and the second liquid cooling film static area 190 do not deform.

Still refer to FIG. 1a and FIG. 15 together. In an implementation, the flexibility-enhancement structure 131 of the first rigid substrate 130 includes a groove 1311 located on a side wall of the first rigid substrate 130, and the groove 1311 is located in the liquid cooling film bending area 170 (as shown in FIG. 1a and FIG. 15).

In this implementation, the first rigid substrate 130 is disposed around an edge of the liquid cooling module 10, and is a barrier between the cooling medium and an external environment. Therefore, the first rigid substrate 130 needs to have high structural strength to ensure a sealing effect, so that the cooling medium does not leak to the outside of the liquid cooling module 10. However, the first rigid substrate 130 located in the liquid cooling film bending area 170 needs to consider both structural strength and specific flexibility. Therefore, the flexibility-enhancement structure 131 disposed on the first rigid substrate 130 is preferably the groove 1311. If a penetration hole, a through hole, or an opening is provided on the first rigid substrate 130, there is a leakage risk of the cooling medium.

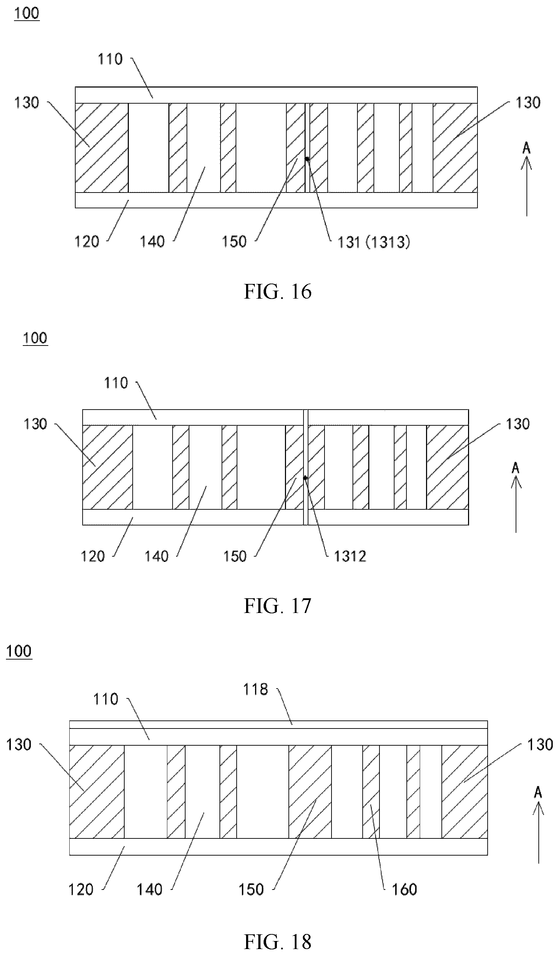

Refer to FIG. 15 and FIG. 16. FIG. 16 is a sectional view of the liquid cooling part 100 according to the first embodiment of this application. In an implementation, the flexibility-enhancement structure 131 of the second rigid substrate 150 includes a through hole 1313 that penetrates the second rigid substrate 150 in a first direction A, the through hole 1313 is located in the liquid cooling film bending area 170, and the first direction A is an arrangement direction of the first flexible film 110 and the second flexible film 120.

In this implementation, the through hole 1313 is provided in the second rigid substrate 150, so that flexibility of the bendable part of the second rigid substrate 150 can be enhanced. Because two sides of the second rigid substrate 150 are respectively provided with the liquid inlet runner 142 and the liquid outlet runner 141, communication of the cooling medium on the two sides cannot be achieved through an opening 1314 on the second rigid substrate 150, to avoid affecting a cooling effect due to mixed flow. The first direction A is also the thickness direction of the liquid cooling part 100.

Refer to FIG. 15 and FIG. 17 together. FIG. 17 is a sectional view of the liquid cooling part 100 according to the first embodiment of this application. In an implementation, the liquid cooling part 100 is provided with a penetration hole 1312 that penetrates the second rigid substrate 150, the first flexible film 110, and the second flexible film 120 in a first direction, and the penetration hole 1312 is located in the liquid cooling film bending area 170.

In this implementation, the penetration hole 1312 is provided in the second rigid substrate 150, so that flexibility of the bendable part of the second rigid substrate 150 can be enhanced, and a rebound force and a friction force of the liquid cooling film bending area 170 during bending can be reduced. The first direction is the thickness direction A of the liquid cooling module 10. The penetration hole 1312 penetrates the second rigid substrate 150 in the first direction, so that a flow short-circuit and mixed flow of the cooling medium in the liquid inlet runner 142 and the liquid outlet runner 141 are not caused. The third rigid substrate 160 may be provided with an opening 1314, to reduce a rebound force of the liquid cooling film bending area 170 and a friction force between the liquid cooling film bending area 170 and each of a screen and a middle frame during bending, and avoid a flow short-circuit of the cooling medium.

In an implementation, the flexibility-enhancement structure 131 of the second rigid substrate 150 includes the through hole 1313 and the penetration hole 1312, or the flexibility-enhancement structure 131 of the second rigid substrate 150 includes either of the through hole 1313 and the penetration hole 1312. In this solution, the through hole 1313 and the penetration hole 1312 may be flexibly provided in the second rigid substrate 150 based on an actual situation, to improve practicability of the second rigid substrate 150 in different application environments.

In an implementation, the flexibility-enhancement structure 131 on the second rigid substrate 150 may alternatively be the groove 1311.

Still refer to FIG. 15. In an implementation, the flexibility-enhancement structure 131 of the third rigid substrate 160 includes the opening 1314 located on the third rigid substrate 160, and runners on the two sides of the third rigid substrate 160 communicate with each other through the opening 1314.

In this implementation, because the liquid cooling film bending area 170 generates large deformation during bending, in this solution, that the third rigid substrate 160 is provided with the opening 1314 means that the third rigid substrate 160 is partially disconnected at the opening 1314, thereby inducing bending deformation at a designed position, and effectively reducing stress generated during bending. A part of the third rigid substrate 160 is distributed in the liquid inlet runner 142, and a part of the third rigid substrate 160 is distributed in the liquid outlet runner 141, that is, the runners on the two sides of the third rigid substrate 160 belong to the liquid inlet runner 142 or the liquid outlet runner 141. Therefore, communication between the two sides of the third rigid substrate 160 through the opening 1314 does not affect heat dissipation efficiency, and a mixed-flow effect of the cooling medium in a same flow direction in the liquid inlet runner 142 or the liquid outlet runner 141 can be improved, thereby improving a cooling effect.

In an implementation, the flexibility-enhancement structure 131 may extend in a flow direction of the cooling medium. In another implementation, the flexibility-enhancement structure 131 may extend in a folding direction of the foldable device. A size of the flexibility-enhancement structure 131 is set to be large in the extension direction, so that flexibility of the liquid cooling film bending area 170 can be effectively enhanced, and a rebound force of the liquid cooling film bending area 170 and a friction force between the liquid cooling film bending area 170 and each of the screen and the middle frame during bending can be reduced. Further, user experience of the foldable device is improved.

FIG. 18 is a sectional view of the liquid cooling part 100 according to the first embodiment of this application. In an implementation, a lubricating material layer 118 is laid on a surface that is of each of the first flexible film 110 and the second flexible film 120 and that is away from the inner cavity 140, and the lubricating material layer 118 is located in the liquid cooling film bending area. In this implementation, to enhance flexibility of the liquid cooling film bending area, in addition to disposing the flexibility-enhancement structures 131 on the first rigid substrate 130, the second rigid substrate 150, and the third rigid substrate 160, the lubricating material layers 118 may be further disposed on outer surfaces of the first flexible film 110 and the second flexible film 120, to reduce a friction force during bending of the liquid cooling film bending area, so that a bending process can be more smoothly performed. For example, the lubricating material layer 118 includes but is not limited to a solid-state, liquid-state, or paste-like lubricating material like a Teflon film, a graphite film, a graphene film, or lubricating grease. When the graphite film or the graphene film is used as the lubricating material layer 118, the lubricating material layer 118 may be disposed in only the liquid cooling film bending area, or may be disposed in the liquid cooling film bending area and at least one of the first liquid cooling film static area and the second liquid cooling film static area. In this case, in addition to having a lubricating and friction reduction function on the liquid cooling film static area, the lubricating material layer 118 can further enhance a heat dissipation effect and reduce an overall temperature of the cooling medium because of a high thermal conductivity coefficient of graphite and graphene, so that start time and a start frequency of the pump are reduced.

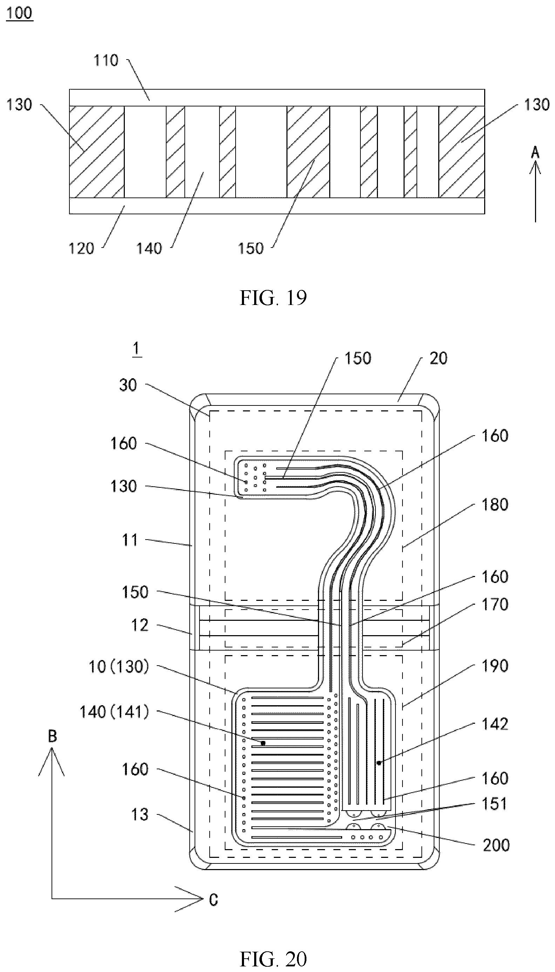

FIG. 19 is a sectional view of the liquid cooling part 100 according to the first embodiment of this application. In an implementation, the liquid cooling part 100 includes a first flexible film 110, a second flexible film 120, and a first rigid substrate 130 located between the first flexible film 110 and the second flexible film 120, the first flexible film 110, the second flexible film 120, and the first rigid substrate 130 enclose the inner cavity 140 of the liquid cooling part 100, and a difference between a glass transition temperature of a material of the first rigid substrate 130 and a glass transition temperature of a material of the first flexible film 110 is less than or equal to 20°C.

In this implementation, the first flexible film 110 and the second flexible film 120 can reduce bending difficulty of an electronic device. The first rigid substrate 130 is configured to enhance structural strength of the liquid cooling part 100 in the thickness direction A. The first flexible film 110, the second flexible film 120, and the first rigid substrate 130 enclose the inner cavity 140, a cooling medium flows in the inner cavity 140, and two ends of the first rigid substrate 130, the first flexible film 110, and the second flexible film 120 are of an integrated sealing structure. This helps improve sealing performance of the first rigid substrate 130 and avoid leakage of the cooling medium.

In this implementation, the difference between the glass transition temperature of the material of the first rigid substrate 130 and the glass transition temperature of the material of the first flexible film 110 is set to a small value, so that the first rigid substrate 130 and the first flexible film 110 are sealed into an integrated structure through thermo compression bonding, thereby improving a sealing effect between the first rigid substrate 130 and the first flexible film 110.

In an implementation, a difference between a melting temperature of a material of the first rigid substrate 130 and a melting temperature of a material of the first flexible film 110 is less than or equal to 20°C. In this implementation, the difference between the melting temperature of the material of the first rigid substrate 130 and the melting temperature of the material of the first flexible film 110 is set to a small value, so that the first rigid substrate 130 and the first flexible film 110 are sealed into an integrated structure through thermo compression bonding, thereby improving a sealing effect between the first rigid substrate 130 and the first flexible film 110.

It should be noted that the foregoing implementations, sizes, position relationships, and structure descriptions of the first flexible film 110, the second flexible film 120, the first rigid substrate 130, the second rigid substrate 150, and the third rigid substrate 160 are applicable to implementations, sizes, position relationships, and structure descriptions of the first flexible film 110, the second flexible film 120, the first rigid substrate 130, the second rigid substrate 150, and the third rigid substrate 160 in this embodiment. Details are not described herein again.

Still refer to FIG. 19. In an implementation, the liquid cooling part 100 includes a first flexible film 110, a second flexible film 120, and a first rigid substrate 130 located between the first flexible film 110 and the second flexible film 120, the first flexible film 110, the second flexible film 120, and the first rigid substrate 130 enclose the inner cavity 140 of the liquid cooling part 100, a material of each of the first flexible film 110, the second flexible film 120, and the first rigid substrate 130 is a flexible temperature-resistant polymer material with elongation at break greater than 10%, and materials of the first flexible film 110, the second flexible film 120, and the first rigid substrate 130 are independently selected from at least one of a polyethylene terephthalate copolymer, polyethylene naphthalate, polyethylene 2,5-furandicarboxylate, polyimide, polyetheretherketone, and biaxially oriented polypropylene.

In this implementation, the first flexible film 110 and the second flexible film 120 can reduce bending difficulty of an electronic device. The first rigid substrate 130 is configured to enhance structural strength of the liquid cooling part 100 in the thickness direction A. The first flexible film 110, the second flexible film 120, and the first rigid substrate 130 enclose the inner cavity 140, a cooling medium flows in the inner cavity 140, and two ends of the first rigid substrate 130, the first flexible film 110, and the second flexible film 120 are of an integrated sealing structure. This helps improve sealing performance of the first rigid substrate 130 and avoid leakage of the cooling medium.

In this implementation, materials selected by the first rigid substrate 130 and the first flexible film 110 or the second flexible film 120 help form an integrated sealing structure between the first rigid substrate 130 and the first flexible film 110 or the second flexible film 120 through hot pressing. The first rigid substrate 130 and the first flexible film 110 or the second flexible film 120 may be made of different materials, provided that an integrated sealing structure can be formed between the first rigid substrate 130 and the first flexible film 110 or the second flexible film 120.

It should be noted that the foregoing implementations, sizes, position relationships, and structure descriptions of the first flexible film 110, the second flexible film 120, the first rigid substrate 130, the second rigid substrate 150, and the third rigid substrate 160 are applicable to implementations, sizes, position relationships, and structure descriptions of the first flexible film 110, the second flexible film 120, the first rigid substrate 130, the second rigid substrate 150, and the third rigid substrate 160 in this embodiment. Details are not described herein again.

Still refer to FIG. 1a. In an implementation, the liquid cooling part 100 includes the first flexible film 110, the second flexible film 120, and a rigid substrate 101 located between the first flexible film 110 and the second flexible film 120. The liquid cooling part 100 includes the liquid cooling film bending area 170. The liquid cooling part 100 is folded through the liquid cooling film bending area 170. The rigid substrate 101 is provided with a flexibility-enhancement structure 131. The flexibility-enhancement structure 131 is located in the liquid cooling film bending area 170. The flexibility-enhancement structure 131 is configured to: enhance flexibility of the liquid cooling film bending area 170, and reduce a rebound force of the liquid cooling film bending area 170 and a friction force between the liquid cooling film bending area 170 and each of the screen and the middle frame during bending.

In this implementation, two ends of the rigid substrate 101 are configured to support the first flexible film 110 and the second flexible film 120, and disposing the rigid substrate 101 in the liquid cooling part 100 helps improve structural strength of the liquid cooling part 100 in the thickness direction A. When an electronic device is bent, large deformation occurs in the liquid cooling film bending area 170 in the liquid cooling part 100. Therefore, the flexibility-enhancement structure 131 needs to be disposed on the rigid substrate 101 located in the liquid cooling film bending area 170, to enhance flexibility of the liquid cooling film bending area 170. In an implementation, the flexibility-enhancement structure 131 may be at least one of the groove 1311, the penetration hole 1312, the through hole 1313, or the opening 1314. In an implementation, the rigid substrate 101 may include the first rigid substrate 130, the second rigid substrate 150, and the third rigid substrate 160.

It should be noted that the foregoing implementations, sizes, position relationships, and structure descriptions of the first flexible film 110, the second flexible film 120, the first rigid substrate 130, the second rigid substrate 150, the third rigid substrate 160, and the flexibility-enhancement structure 131 are applicable to implementations, sizes, position relationships, and structure descriptions of the first flexible film 110, the second flexible film 120, the first rigid substrate 130, the second rigid substrate 150, the third rigid substrate 160, and the flexibility-enhancement structure 131 in this embodiment. Details are not described herein again.

The liquid cooling module 10 provided in embodiments of this application may be used in the electronic device.

FIG. 20 is a schematic diagram of a structure of an electronic device 1 according to the first embodiment of this application. In an implementation, the electronic device 1 includes a housing 20, and an electronic functional component 30 and a liquid cooling module 10 that are located in the housing 20, where the liquid cooling module 10 is located outside the housing 20.

In this implementation, for example, the electronic device 1 may be an electronic product like a mobile phone, a tablet computer, a notebook computer, or a wearable device. The electronic functional component 30 in the electronic device 1 includes but is not limited to a processor, an internal memory, a charging management module, a power management module, a battery, an antenna, a communication module, a camera, an audio module, a loudspeaker, a receiver, a microphone, a sensor module, a motor, an indicator, and the like. The electronic device 1 may have more or fewer electronic functional components 30 than those described above. Various electronic functional components 30 may be implemented in hardware, software, or a combination of hardware and software including one or more signal processing and/or application-specific integrated circuits. The electronic functional component 30 releases heat in a working state. When a temperature inside the electronic device 1 is excessively high, working efficiency of the electronic functional component 30 and a service life of the electronic device 1 are affected. Therefore, the liquid cooling module 10 needs to be disposed, to perform temperature rise control on the electronic functional component 30.

In an implementation, the liquid cooling module 10 is located between the housing 20 and the electronic functional component 30.

In a first embodiment shown in FIG. 20, the electronic device 1 is a foldable device, and has an unfolded state and a folded state. The electronic device 1 includes a first non-folding part 11, a folding part 12, and a second non-folding part 13, and the second non-folding part 13 is foldable toward the first non-folding part 11 through the folding part 12. The liquid cooling module 10 may be sequentially separated into the first liquid cooling film static area 180, the liquid cooling film bending area 170, and the second liquid cooling film static area 190 in a length direction B. When the electronic device 1 is in the folded state, the liquid cooling part 100 is folded through the liquid cooling film bending area 170. In this case, the liquid cooling film bending area 170 is bent, and the first liquid cooling film static area 180 and the second liquid cooling film static area 190 do not deform. If a foldable machine has three or more N foldable screens, correspondingly, there may be a maximum of three or N liquid cooling parts, two or N-1 bending areas, at least two liquid cooling films, and one bending area, where N is an integer greater than 2. For a bar phone, there is no bending area and one or more liquid cooling films. According to a performance requirement of a liquid cooling system, one or more liquid pumps may be disposed, and may be connected in parallel, in series, or in a hybrid manner, or may be disposed adjacently or not adjacently, for example, disposed near mainboards of different screens. The pump may have pressure fluctuation, micro-vibration of 2 um to 50 um, and noise in operation. The flexible liquid cooling part helps absorb pressure fluctuation, and reduce volume variation and vibration noise.

The first rigid substrate 130 is disposed in a closed manner around an edge of the first liquid cooling film static area 180, an edge of the liquid cooling film bending area 170, and an edge of the second liquid cooling film static area 190. The pump 200 is located in the second liquid cooling film static area 190 and is disposed close to the first rigid substrate 130 in a width direction C, and the third rigid substrate 160 is disposed on each of two sides of the pump 200 in a length direction B, where the third rigid substrates 160 on the two sides of the pump 200 in the length direction B are respectively columnar and bar-shaped. In this implementation, a damping material is usually spaced or added between the pump 200 and each of an adjacent first flexible film 110, the second flexible film 120, and another mechanical part in the electronic device 1. The damping material may be bonded to the first flexible film 110, the second flexible film 120, or the mechanical part. For example, the mechanical part may be at least one of the display, the housing 20, the battery, and the camera.

The second rigid substrate 150 is disposed on a side that is of the pump 200 and that is away from the first rigid substrate 130 in the width direction C, and the second rigid substrate 150 separates the inner cavity 140 enclosed by the second liquid cooling film static area 190, the liquid cooling film bending area 170, and a part of the first liquid cooling film static area 180 into the liquid inlet runner 142 and the liquid outlet runner 141. Specifically, in the second liquid cooling film static area 190, a part of the second rigid substrate 150 extends in the width direction C, and a part of the second rigid substrate 150 extends in the length direction B. The second rigid substrate 150 extending in the length direction B separates the inner cavity 140 located on two sides of the width direction C into the liquid inlet runner 142 and the liquid outlet runner 141, and the second rigid substrate 150 extending in the width direction C is configured to guide, together with the third rigid substrate 160, flow of the cooling medium flowing out of the pump 200. In the liquid inlet runner 142 of the second liquid cooling film static area 190, the third rigid substrate 160 may be bar-shaped or columnar, where the third rigid substrate 160 in a bar shape extends in the width direction C, and the third rigid substrate 160 in a column shape is disposed on two sides of the third rigid substrate 160 in the bar shape in the width direction C. In the liquid outlet runner 141 of the second liquid cooling film static area 190, the third rigid substrate 160 is bar-shaped and extends in the length direction B. An area enclosed by the first rigid substrate 130 in the second liquid cooling film static area 190 is basically rectangular or square.

In the liquid cooling film bending area 170, the second rigid substrate 150 extends in the length direction B, and the second rigid substrate 150 separates the inner cavity 140 located on the two sides of the second rigid substrate 150 in the width direction C into the liquid inlet runner 142 and the liquid outlet runner 141, where the third rigid substrate 160 in both the liquid inlet runner 142 and the liquid outlet runner 141 is bar-shaped and extends in the length direction B. An area enclosed by the first rigid substrate 130 in the liquid cooling film bending area 170 is basically bar-shaped. In this embodiment, the liquid cooling module 10 in the liquid cooling film bending area 170 is disposed in a cross-hinge manner, that is, the liquid cooling module 10 crosses a main shaft of the liquid cooling film bending area 170.

In the first liquid cooling film static area 180, a part of the second rigid substrate 150 in an "inverted C shape", and a part of the second rigid substrate 150 is bar-shaped and extends in the width direction C. The second rigid substrate 150 in the "inverted C type" separates the inner cavity 140 into the liquid inlet runner 142 and the liquid outlet runner 141, and the third rigid substrate 160 on two sides of the second rigid substrate 150 in the "inverted C type" is in the "inverted C type". The third rigid substrate 160 in a column shape is disposed at a tail end of the second rigid substrate 150 in the bar shape along a side of the width direction C, and the liquid inlet runner 142 and the liquid outlet runner 141 communicate with each other on the third rigid substrate 160, to form a cooling cycle.

In an implementation, a thickness of the first rigid substrate 130, a thickness of the second rigid substrate 150, and a thickness of the third rigid substrate 160 are unequal, and any one of the thickness of the first rigid substrate 130, the thickness of the second rigid substrate 150, and the thickness of the third rigid substrate 160 may be 0.1 mm to 1 mm. This solution helps meet architectural space requirements of the liquid cooling module 10 in different application environments. Preferably, any one of the thickness of the first rigid substrate 130, the thickness of the second rigid substrate 150, and the thickness of the third rigid substrate 160 may be 0.15 mm to 0.3 mm.

In an implementation, a density of the first flexible film 110 and a density of the second flexible film 120 are less than or equal to 2 g/ml. This solution helps reduce an overall weight of the liquid cooling module 10, and enables the first flexible film 110 and the second flexible film 120 to more flexibly adapt to different architecture environments.

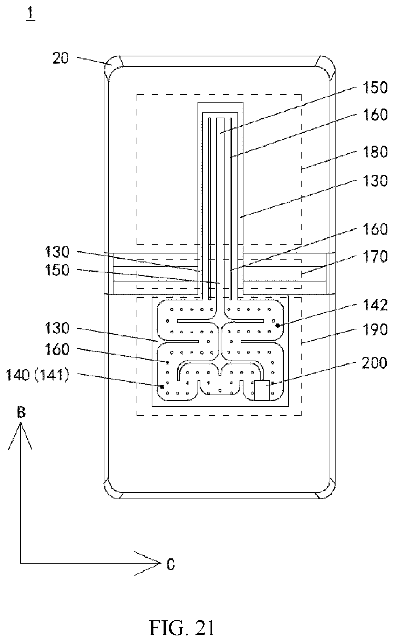

FIG. 21 is a diagram of a structure of the electronic device 1 according to a second embodiment of this application. Different from the first embodiment, in the second embodiment, the liquid cooling module 10 may be in a shape different from that in the first embodiment. In an implementation, in the second liquid cooling film static area 190, the first rigid substrate 130 is disposed around an edge of the liquid cooling module 10, the second rigid substrate 150 is in a shape in which two "cross" shapes are connected end to end, and two ends of the second rigid substrate 150 in one "cross" shape are curved in the width direction C. In this case, the inner cavity 140 is in a shape in which a plurality of "C" shapes with different opening directions are connected end to end. The pump 200 is located at an end of the second liquid cooling film static area 190 in the width direction C, the third rigid substrate 160 in the second liquid cooling film static area 190 is columnar, one end of the second rigid substrate 150 that is curved at two ends is adjacent to the pump 200, and the inner cavity 140 is separated into the liquid inlet runner 142 and the liquid outlet runner 141. In the liquid cooling film bending area 170, the liquid cooling module 10 is in integrally long-bar-shaped, where the second rigid substrate 150 is bar-shaped and extends in the length direction B, and the third rigid substrate 160 located on two sides of the second rigid substrate 150 in the width direction C is bar-shaped and extends in the length direction B. In the first liquid cooling film static area 180, the liquid cooling module 10 is integrally long-bar-shaped, where the second rigid substrate 150 is bar-shaped and extends in the length direction B, the third rigid substrate 160 located on two sides of the second rigid substrate 150 in the width direction C is bar-shaped and extends in the length direction B, and the liquid inlet runner 142 and the liquid outlet runner 141 communicate with each other in the first liquid cooling film static area 180, to form a cooling cycle.

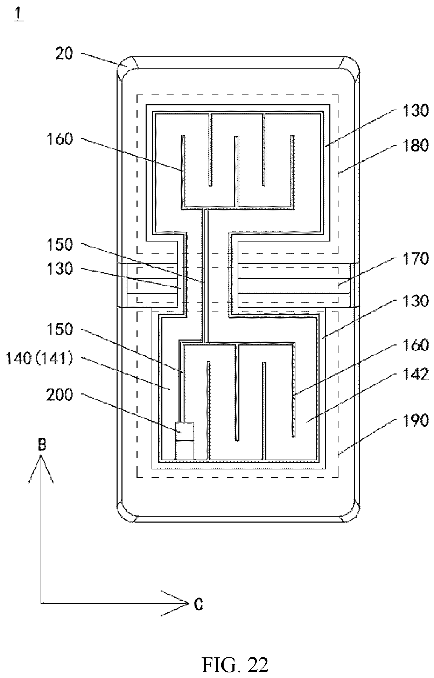

FIG. 22 is a diagram of the structure of the electronic device 1 according to the second embodiment of this application. In another implementation, in the second liquid cooling film static area 190, the first rigid substrate 130 is disposed around an edge of the liquid cooling module 10, the pump 200 is located in the second liquid cooling film static area 190 and is disposed close to the first rigid substrate 130 in the length direction B and the width direction C, and the second rigid substrate 150 first extends in the length direction B, then extends in the width direction C, and then extends to the liquid cooling film bending area 170 in the length direction B. An end that is of the second rigid substrate 150, away from the liquid cooling film bending area 170, and extends in the length direction B is disposed close to the pump 200, to separate the inner cavity 140 into the liquid inlet runner 142 and the liquid outlet runner 141. No third rigid substrate 160 is disposed in the liquid inlet runner 142. In the liquid outlet runner 141, the third rigid substrate 160 extends in the length direction B and parts of the third rigid substrate 160 are alternately spaced from each other. In this case, the liquid outlet runner 141 is finally in a shape in which a plurality of "C" shapes with different opening directions are connected end to end. In the liquid cooling film bending area 170, the second rigid substrate 150 is bar-shaped and extends in the length direction B. In the first liquid cooling film static area 180, the liquid inlet runner 142 communicates with the liquid outlet runner 141 to form a cooling cycle, where the third rigid substrate 160 in the first liquid cooling film static area 180 is similar to the third rigid substrate 160 in the second liquid cooling film static area 190 in shape and distribution characteristics. Details are not described herein again.

It should be noted that the foregoing implementations, sizes, position relationships, and structure descriptions of the pump 200, the first flexible film 110, the second flexible film 120, the first rigid substrate 130, the second rigid substrate 150, and the third rigid substrate 160 in the first embodiment are applicable to the implementations, sizes, position relationships, and structure descriptions of the pump 200, the first flexible film 110, the second flexible film 120, the first rigid substrate 130, the second rigid substrate 150, and the third rigid substrate 160 in the second embodiment. Details are not described herein again.

In an existing VC/HP design solution of a mobile phone, a VC cover or a heat pipe is made of a copper alloy and stainless steel, with a density of 8.9 g/ml or 7.8 g/mL. The VC cover or the heat pipe cannot pass 100,000 to 200,000 bending tests (R being 1.5 mm), and cannot implement through-axis or cross-axis heat dissipation. A cross-axis or through-axis graphite material is used for heat dissipation, and has an equivalent thermal conductivity less than or equal to 2000 W/m·K. According to the flexible liquid cooling module solution in this embodiment of this application, the equivalent thermal conductivity may alternatively be 5000 W/m·K, and a partial unequal-thickness design can be adopted to partially achieve a thickness of 0.15 mm, so as to meet requirements of a chip and architecture space. A liquid cooling film is made of modified PET, and has a density less than or equal to 2 g/mL, so that a more flexible architecture design can be implemented, and a heat dissipation capability is improved by more than 50% in comparison with that of graphite. A heat dissipation capability of the liquid cooling film module provided in embodiments of this application is improved by more than 50% in comparison with that of the cross-axis/through-axis graphite.

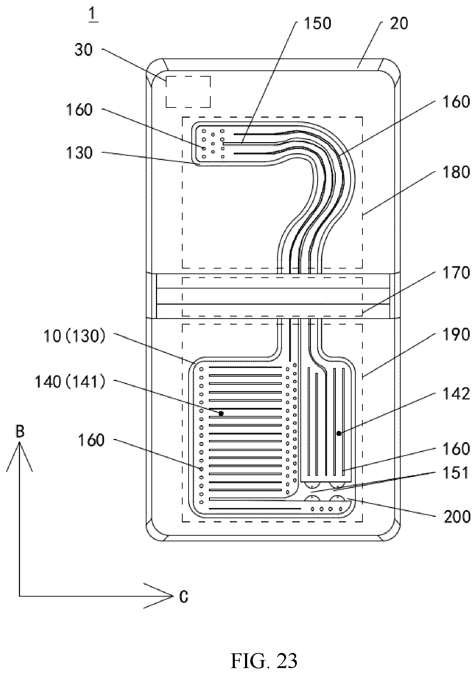

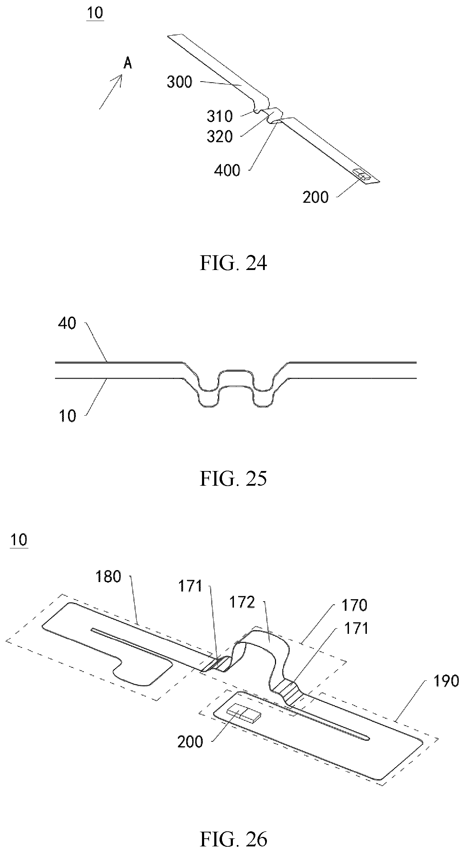

Refer to FIG. 23 and FIG. 24. FIG. 23 is a diagram of a structure of the electronic device 1 according to a third embodiment of this application; and FIG. 24 is a diagram of a partial structure of the liquid cooling module 10 according to the third embodiment of this application. Different from the first embodiment, in the third embodiment, the liquid cooling module 10 in the liquid cooling film bending area 170 is disposed in a through-hinge manner. In this embodiment, the liquid cooling module 10 includes a first surface 300 and a second surface 400 that are disposed opposite to each other in the thickness direction A. The liquid cooling module 10 located in the liquid cooling film bending area 170 is provided with two curved portions 310 that are spaced from each other. An area other than the curved portions 310 in the liquid cooling module 10 is a base part 320. The first surface 300 and the second surface 400 of the two curved portions 310 are bent in the thickness direction A, and the second surface 400 facing the base part 320 is away from the first surface 300. The two curved portions 310 and the base part 320 located between the two curved portions 310 are in a ripple shape, and a main shaft penetrates an area enclosed by the two curved portions 310 and the base part 320 between the two curved portions 310. In a process in which the electronic device 1 is folded and unfolded, in this solution, stress generated when the liquid cooling film bending area 170 deforms can be reduced, thereby improving user experience. In an actual product design, there may be a plurality of curved portions 310 and base parts 320, and the curved portions 310 and the base parts 320 may not be designed symmetrically.

FIG. 25 is a diagram of structures of the liquid cooling module 10 and a flexible circuit board 40 according to the third embodiment of this application. In an implementation, the electronic device further includes the flexible circuit board 40, where the flexible circuit board 40 is configured to electrically connect to an electronic functional component, and the flexible circuit board 40 and the liquid cooling module 10 are jointly disposed in a through-hinge manner. In this implementation, the liquid cooling module 10 located in the liquid cooling film bending area 170 is disposed through attaching, and both the flexible circuit board 40 and the liquid cooling module 10 are in a ripple shape, and share through-hinge space. This helps reduce friction, collision, and abnormal sound between the liquid cooling module 10 and the flexible circuit board 40. In an implementation, a plastic deformation method may be used to keep the flexible circuit board 40 in the ripple shape.

In an implementation, an air gap is partially or completely provided between the flexible circuit board 40 and the liquid cooling module 10. In this solution, the air gap can be set to effectively avoid a problem of a bending rebound force.

It should be noted that the foregoing implementations, sizes, position relationships, and structure descriptions of the pump 200, the first flexible film 110, the second flexible film 120, the first rigid substrate 130, the second rigid substrate 150, and the third rigid substrate 160 in the first embodiment are applicable to the implementations, sizes, position relationships, and structure descriptions of the pump 200, the first flexible film 110, the second flexible film 120, the first rigid substrate 130, the second rigid substrate 150, and the third rigid substrate 160 in the third embodiment. Details are not described herein again.

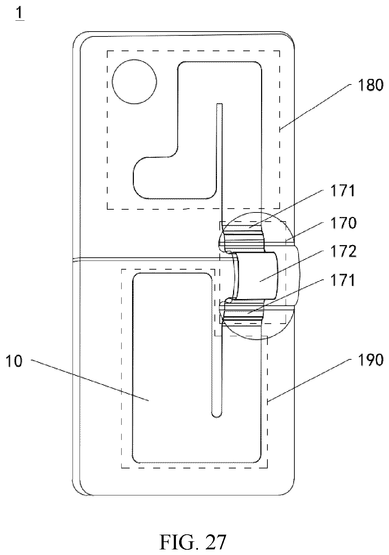

Refer to FIG. 26 and FIG. 27. FIG. 26 is a diagram of a structure of the liquid cooling module 10 according to the fourth embodiment of this application; and FIG. 27 is a diagram of a structure of an electronic device according to an embodiment of this application. Different from the first embodiment, in the fourth embodiment, the liquid cooling module 10 is an external accessory relative to the electronic device 1. In this embodiment, the liquid cooling module 10 includes the first liquid cooling film static area 180, the liquid cooling film bending area 170, and the second liquid cooling film static area 190, where the liquid cooling film bending area 170 includes two first bent portions 171 and one second bent portion 172, the second bent portion 172 is located between the two first bent portions 171, and a bending degree of the second bent portion 172 is greater than that of the first bent portion 171. When the electronic device is folded, a deformed portion of the electronic device moves to the accommodating space formed by a surface of the second bent portion 172, and the first bent portion 171 deforms along with the electronic device. In this solution, the liquid cooling module 10 is disposed as an external accessory, to decouple the liquid cooling module 10 from sensitive components such as a display and a battery of the electronic device, so that the liquid cooling module 10 is designed flexibly and replaced more conveniently.

It should be noted that the foregoing implementations, sizes, position relationships, and structure descriptions of the pump 200, the first flexible film 110, the second flexible film 120, the first rigid substrate 130, the second rigid substrate 150, and the third rigid substrate 160 in the first embodiment are applicable to the implementations, sizes, position relationships, and structure descriptions of the pump 200, the first flexible film 110, the second flexible film 120, the first rigid substrate 130, the second rigid substrate 150, and the third rigid substrate 160 in the fourth embodiment. Details are not described herein again.

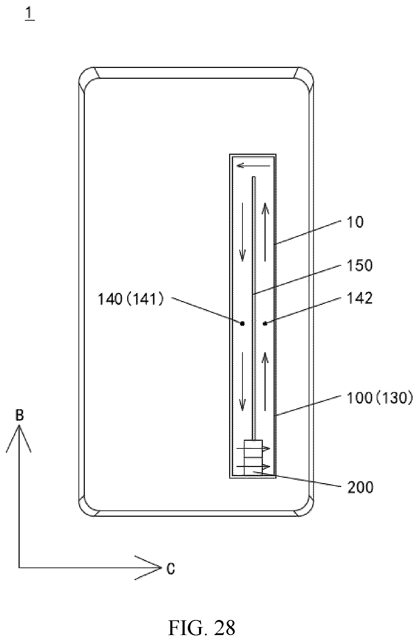

FIG. 28 is a diagram of a structure of the electronic device 1 according to a fifth embodiment of this application. Different from the first embodiment, in the second embodiment, the electronic device 1 is a device that cannot be folded, and the electronic device 1 is not in a folded state. In this embodiment, the liquid cooling part 100 includes a first flexible film, a second flexible film, a first rigid substrate 130, and a second rigid substrate 150, and the first rigid substrate 130 is disposed in a closed manner around an edge of the liquid cooling module 10. The pump is disposed close to the first rigid substrate 130 in the length direction B. A side that is of the pump 200 and that is away from the first rigid substrate 130 in the length direction B is provided with the second rigid substrate 150, the second rigid substrate 150 extends in the length direction B, and the inner cavity 140 located on two sides of the second rigid substrate 150 in the width direction C are separated into the liquid inlet runner 142 and the liquid outlet runner 141. The liquid inlet runner 142 and the liquid outlet runner 141 communicate with each other on a side of that is of the second rigid substrate 150 and that is away from the pump 200 in the length direction B, form a cooling cycle. FIG. 28 shows a flow direction of a liquid working medium. Two pumps are designed in parallel to form circulating flow.

In an implementation, a thickness of the first rigid substrate 130 and a thickness of the second rigid substrate 150 are unequal, either of the thickness of the first rigid substrate 130 and the thickness of the second rigid substrate 150 may be 0.1 mm to 1 mm. This solution helps meet architectural space requirements of the liquid cooling module 10 in different application environments. Preferably, either of the thickness of the first rigid substrate 130 and the thickness of the second rigid substrate 150 may be 0.15 mm to 0.3 mm.

In an implementation, a density of the first flexible film 110 and a density of the second flexible film 120 are less than or equal to 2 g/ml. This solution helps reduce an overall weight of the liquid cooling module 10, and enables the first flexible film 110 and the second flexible film 120 to more flexibly adapt to different architecture environments.

It should be noted that the foregoing implementations, position relationships, and structure descriptions of the pump 200, the first flexible film 110, the second flexible film 120, the first rigid substrate 130, and the second rigid substrate 150 in the first embodiment are applicable to the implementations, position relationships, and structure descriptions of the pump 200, the first flexible film 110, the second flexible film 120, the first rigid substrate 130, and the second rigid substrate 150 in the fifth embodiment. Details are not described herein again.

An existing bar phone adopts a VC/HP design solution. VC/HP is a variable electric heat-conducting pipe with an equivalent thermal conductivity of 5000 W/m·K, and has an equal-thickness design with a thickness greater than or equal to 0.25 mm. A VC cover or heat pipe is made of a copper alloy or stainless steel with a density of 8.9 g/ml or 7.8 g/mL. According to the flexible liquid cooling film solution in this embodiment of this application, the equivalent thermal conductivity may alternatively be 5000 W/m·K, and a partial unequal-thickness design can be adopted to partially achieve a thickness of 0.15 mm, so as to meet requirements of a chip and architecture space. A liquid cooling part is made of modified PET and has a density of less than or equal to 2 g/mL, so that a more flexible architecture design, a smaller weight, and a higher heat dissipation capability can be implemented. In other words, with a same heat dissipation capability as the VC, the liquid cooling part can be in an unequal-thickness design, so that the weight can be reduced by more than 50%.

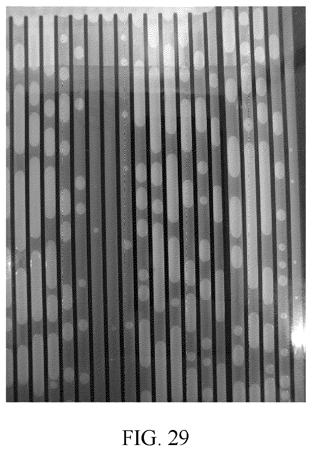

FIG. 29 is a diagram of a liquid cooling module according to an embodiment of this application. In an implementation, a cooling medium in the liquid cooling part 100 may be a single-phase cooling medium, or a cooling medium of two or more colors that are incompatible with each other, so that flow of the cooling medium is more visualized, and user experience is improved.

The liquid cooling module, the liquid cooling part, and electronic device provided in embodiments of this application are described in detail above. The principle and embodiments of this specification are described herein with specific examples. The descriptions about the foregoing embodiments are merely provided to help understand the method and core ideas of this application. In addition, a person of ordinary skill in the art can make modifications to specific embodiments and application scopes according to the ideas of this application. Therefore, in conclusion, the content of this specification shall not be construed as a limitation on this application.

## Claims

1. A liquid cooling module (10), wherein the liquid cooling module (10) comprises:
a pump (200), wherein the pump (200) comprises a pump base (210) and a piezoelectric component (220) fastened to the pump base (210), and a pump liquid inlet (211) and a pump liquid outlet (212) are disposed on the pump base (210); and
a liquid cooling part (100), wherein the liquid cooling part (100) comprises a liquid cooling outlet (111) and a liquid cooling inlet (112), the liquid cooling outlet (111) is configured to communicate with the pump liquid inlet (211), the liquid cooling inlet (112) is configured to communicate with the pump liquid outlet (212), a part of the liquid cooling part (100) on a periphery of the liquid cooling outlet (111) and a part of the pump base (210) on a periphery of the pump liquid inlet (211) are of an integrated sealing structure, and a part of the liquid cooling part (100) on a periphery of the liquid cooling inlet (112) and a part of the pump base (210) on a periphery of the pump liquid outlet (212) are of an integrated sealing structure.

2. The liquid cooling module (10) according to claim 1, wherein at least a part of the part of liquid cooling part (100) on the periphery of the liquid cooling outlet (111) and at least a part of the part of the pump base (210) on the periphery of the pump liquid inlet (211) are continuously integrated in a circumferential direction (D) of the liquid cooling outlet (111), to form an integrated sealing structure.

3. The liquid cooling module (10) according to claim 1, wherein the pump base (210) comprises a pump bottom wall (213), the pump bottom wall (213), the piezoelectric component (220), and a part of the pump base (210) between the pump bottom wall (213) and the piezoelectric component (220) enclose a pump cavity (214), the pump liquid inlet (211) and the pump liquid outlet (212) are disposed on the pump bottom wall (213) and communicate with the pump cavity (214), and the pump bottom wall (213), the part of the liquid cooling part (100) on the periphery of the liquid cooling outlet (111), and the part of the liquid cooling part (100) on the periphery of the liquid cooling inlet (112) are of an integrated sealing structure.

4. The liquid cooling module (10) according to claim 1, wherein the pump base (210) further comprises a pump side wall (215) located between the pump bottom wall (213) and the piezoelectric component (220), and the pump side wall (215) is of an integrated sealing structure.

5. The liquid cooling module (10) according to claim 3, wherein the liquid cooling part (100) comprises a first flexible film (110), the liquid cooling outlet (111) and the liquid cooling inlet (112) are disposed on the first flexible film (110), and the pump bottom wall (213), a part of the first flexible film (110) on the periphery of the liquid cooling outlet (111), and a part of the first flexible film (110) on the periphery of the liquid cooling inlet (112) are of an integrated sealing structure.

6. The liquid cooling module (10) according to claim 3, wherein a difference between a glass transition temperature of a material of the pump bottom wall (213) and a glass transition temperature of a material of the first flexible film (110) is less than or equal to 20°C; or
a difference between a melting temperature of a material of the pump bottom wall (213) and a melting temperature of a material of the first flexible film (110) is less than or equal to 20°C; or
a material of the part of the liquid cooling part (100) on the periphery of the liquid cooling outlet (111) is the same as a material of the part of the pump base (210) on the periphery of the pump liquid inlet (211), and a material of the part of the liquid cooling part (100) on the periphery of the liquid cooling inlet (112) is the same as a material of the part of the pump base (210) on the periphery of the pump liquid outlet (212).

7. The liquid cooling module (10) according to claim 3, wherein a material of the pump bottom wall (213) is a flexible temperature-resistant polymer material with elongation at break greater than 10%, and the material of the pump bottom wall (213) is selected from at least one of a polyethylene terephthalate copolymer, polyethylene naphthalate, polyethylene 2,5-furandicarboxylate, polyimide, polyetheretherketone, and biaxially oriented polypropylene; and
a material of the first flexible film (110) is a flexible temperature-resistant polymer material with elongation at break greater than 10%, and the material of the first flexible film (110) is selected from at least one of a polyethylene terephthalate copolymer, polyethylene naphthalate, polyethylene 2,5-furandicarboxylate, polyimide, polyetheretherketone, and biaxially oriented polypropylene.

8. The liquid cooling module (10) according to claim 7, wherein a monomer of the polyethylene terephthalate copolymer comprises terephthalic acid, ethylene glycol, and a hard segment molecular structure, and a value of a mass percentage of the hard segment molecular structure to the polyethylene terephthalate copolymer is greater than or equal to 20% and less than or equal to 80%.

9. The liquid cooling module (10) according to claim 8, wherein the hard segment molecular structure is selected from at least one of 2,5-furandicarboxylic acid, dimethyl carbonate, and 2,6-naphthalenedicarboxylic acid.

10. The liquid cooling module (10) according to claim 5, wherein the liquid cooling part (100) further comprises a second flexible film (120) and a first rigid substrate (130) located between the first flexible film (110) and the second flexible film (120), wherein the first flexible film (110), the second flexible film (120), and the first rigid substrate (130) enclose an inner cavity (140) of the liquid cooling part (100), and two ends of the first rigid substrate (130), the first flexible film (110), and the second flexible film (120) are of an integrated sealing structure.

11. The liquid cooling module (10) according to claim 10, wherein a difference between a glass transition temperature of a material of the first rigid substrate (130) and a glass transition temperature of a material of the first flexible film (110) or the second flexible film (120) is less than or equal to 20°C; or
a difference between a melting temperature of a material of the first rigid substrate (130) and a melting temperature of a material of the first flexible film (110) or the second flexible film (120) is less than or equal to 20°C.

12. The liquid cooling module (10) according to claim 10, wherein at least one of the first flexible film (110) and the second flexible film (120) comprises two sub-flexible film layers (115) and an anti-evaporation layer (116) located between the two sub-flexible film layers (115), and the anti-evaporation layer (116) comprises at least one of a polyimide layer, a polyvinylidene chloride layer, or a metal film layer.

13. The liquid cooling module (10) according to claim 10, wherein an inorganic oxide film (117) is provided on a surface that is of at least one of the first flexible film (110) and the second flexible film (120) and that is away from the inner cavity (140).

14. The liquid cooling module (10) according to claim 10, wherein the liquid cooling part (100) further comprises a second rigid substrate (150), the second rigid substrate (150) separates the inner cavity (140) of the liquid cooling part (100) into a liquid inlet runner (142) and a liquid outlet runner (141), the liquid cooling inlet (112) communicates with the liquid inlet runner (142), the liquid cooling outlet (111) communicates with the liquid outlet runner (141), and two ends of the second rigid substrate (150), the first flexible film (110), and the second flexible film (120) are of an integrated sealing structure.

15. The liquid cooling module (10) according to claim 14, wherein the liquid cooling part (100) further comprises a third rigid substrate (160), the third rigid substrate (160) is distributed in the liquid inlet runner (142) and the liquid outlet runner (141), and two ends of the third rigid substrate (160), the first flexible film (110), and the second flexible film (120) are of an integrated sealing structure.

16. The liquid cooling module (10) according to claim 15, wherein the liquid cooling part (100) comprises a liquid cooling film bending area (170), the liquid cooling part (100) is folded through the liquid cooling film bending area (170), at least one of the first rigid substrate (130), the second rigid substrate (150), and the third rigid substrate (160) is provided with a flexibility-enhancement structure (131), the flexibility-enhancement structure (131) is located in the liquid cooling film bending area (170), and the flexibility-enhancement structure (131) is configured to enhance flexibility of the liquid cooling film bending area (170).

17. The liquid cooling module (10) according to claim 16, wherein the flexibility-enhancement structure (131) of the first rigid substrate(130) comprises a groove (1311) located on a side wall of the first rigid substrate (130), and the groove (1311) is located in the liquid cooling film bending area (170).

18. The liquid cooling module (10) according to claim 16, wherein the flexibility-enhancement structure (131) of the second rigid substrate(150) comprises a through hole (1313) that penetrates the second rigid substrate (150) in a first direction (A), the through hole (1313) is located in the liquid cooling film bending area (170), and the first direction (A) is an arrangement direction of the first flexible film (110) and the second flexible film (120); or
the liquid cooling part (100) is provided with a penetration hole (1312) that penetrates the second rigid substrate (150), the first flexible film (110), and the second flexible film (120) in a first direction (A), and the penetration hole (1312) is located in the liquid cooling film bending area (170).

19. The liquid cooling module (10) according to claim 16, wherein the flexibility-enhancement structure (131) of the third rigid substrate (160) comprises an opening (1314) located on the third rigid substrate (160), and runners on two sides of the third rigid substrate (160) communicate with each other through the opening (1314).

20. A liquid cooling part (100), wherein the liquid cooling part (100) comprises a first flexible film (110), a second flexible film (120), and a first rigid substrate (130) located between the first flexible film (110) and the second flexible film (120), the first flexible film (110), the second flexible film (120), and the first rigid substrate (130) enclose an inner cavity (140) of the liquid cooling part (100), and a difference between a glass transition temperature of a material of the first rigid substrate (130) and a glass transition temperature of a material of the first flexible film (110) is less than or equal to 20°C; or
a difference between a melting temperature of a material of the first rigid substrate (130) and a melting temperature of a material of the first flexible film (110) is less than or equal to 20°C.

21. A liquid cooling part (100), wherein the liquid cooling part (100) comprises a first flexible film (110), a second flexible film (120), and a first rigid substrate (130) located between the first flexible film (110) and the second flexible film (120), the first flexible film (110), the second flexible film (120), and the first rigid substrate (130) enclose an inner cavity (140) of the liquid cooling part (100), a material of each of the first flexible film (110), the second flexible film (120), and the first rigid substrate (130) is a flexible temperature-resistant polymer material with elongation at break greater than 10%, and materials of the first flexible film (110), the second flexible film (120), and the first rigid substrate (130) are independently selected from at least one of a polyethylene terephthalate copolymer, polyethylene naphthalate, polyethylene 2,5-furandicarboxylate, polyimide, polyetheretherketone, and biaxially oriented polypropylene.

22. A liquid cooling part (100), wherein the liquid cooling part (100) comprises a first flexible film (110), a second flexible film (120), and a rigid substrate (101) located between the first flexible film (110) and the second flexible film (120), the liquid cooling part (100) comprises a liquid cooling film bending area (170), the liquid cooling part (100) is folded through the liquid cooling film bending area (170), the rigid substrate (101) is provided with a flexibility-enhancement structure (131), the flexibility-enhancement structure (131) is located in the liquid cooling film bending area (170), and the flexibility-enhancement structure (131) is configured to enhance flexibility of the liquid cooling film bending area (170).

23. An electronic device (1), comprising the liquid cooling module (10) according to any one of claims 1 to 19, wherein the liquid cooling module (10) is located in the electronic device (1), or located in an accessory of the electronic device (1); or
comprising the liquid cooling part (100) according to any one of claims 20 to 22, wherein the liquid cooling part (100) is located in the electronic device (1), or located in an accessory of the electronic device (1).

24. The electronic device (1) according to claim 1, wherein when the electronic device (1) comprises a first non-folding part (11), a folding part (12), and a second non-folding part (13), the second non-folding part (13) is foldable toward the first non-folding part (11) through the folding part (12), the liquid cooling part (100) comprises the liquid cooling film bending area (170), when the electronic device (1) is folded, the liquid cooling part (100) is folded through the liquid cooling film bending area (170), at least one of the first rigid substrate (130), the second rigid substrate (150), and the third rigid substrate (160) is provided with the flexibility-enhancement structure (131), the flexibility-enhancement structure (131) is located in the liquid cooling film bending area (170), and the flexibility-enhancement structure (131) is configured to enhance flexibility of the liquid cooling film bending area (170).
